# EUROPÄISCHE PATENTSCHRIFT

(11) **EP 1 761 999 B1**
(45) Veröffentlichungstag und Bekanntmachung des Hinweises auf die Patenterteilung: **10.06.2009**
(21) Anmeldenummer: 05750589.3
(22) Anmeldetag: 21.06.2005
(51) Int. Cl.: H01L 41/09, G02B 7/00

(54) **ANTRIEBSEINHEIT**
DRIVE UNIT
UNITE D'ENTRAINEMENT

(30) Priorität: 24.06.2004 CH 106604; 30.12.2004 CH 216704
(43) Veröffentlichungstag der Anmeldung: 14.03.2007
(73) Patentinhaber: MINISWYS SA, 2503 Biel (CH)
(72) Erfinder: WITTEVEEN, Bonny, NL-5915 HP Venlo (NL); MOCK, Elmar, CH-2013 Colombier (CH); DAAMEN, Edwin, NL-6121 NP Born (NL); KAUFMANN, Florian, CH-4500 Solothurn (CH)
(74) Vertreter: Frei Patent Attorneys
(86) Internationale Anmeldenummer: PCT/CH2005/000343
(87) Internationale Veröffentlichungsnummer: WO 2006/000118

(56) Entgegenhaltungen:
- EP-A- 0 642 180
- EP-A- 1 137 054
- WO-A-01/41228
- WO-A-03/036786
- WO-A-03/048831
- US-A1- 2004 095 040
- US-A1- 2004 212 794
- PATENT ABSTRACTS OF JAPAN Bd. 009, Nr. 216 (E-340), 3. September 1985 (1985-09-03) -& JP 60 074982 A (HITACHI MAXELL KK), 27. April 1985 (1985-04-27)
- PATENT ABSTRACTS OF JAPAN Bd. 012, Nr. 146 (E-605), 6. Mai 1988 (1988-05-06) -& JP 62 262676 A (MURATA MFG CO LTD), 14. November 1987 (1987-11-14)
- DATABASE WPI Section EI, Week 198128 Derwent Publications Ltd., London, GB; Class T03, AN 1981-G5333D XP002328208 -& SU 773 715 A (KISHKIS V S) 23. Oktober 1980 (1980-10-23)

## Beschreibung

Die Erfindung betrifft das Gebiet der elektrischen Antriebe, insbesondere der piezoelektrischen Antriebe. Sie bezieht sich auf eine Antriebseinheit und eine Positionierungseinheit zur Positionierung eines optischen Elementes gemäss dem Oberbegriff der entsprechenden unabhängigen Patentansprüche.

### STAND DER TECHNIK

Aus der Druckschrift WO 01/041 228 ist ein piezoelektrischer Motor bekannt, bei welchem ein Antriebselement, bestehend aus einem Piezoelement und Kontaktelementen, flexibel montiert ist und dadurch in Schwingungen zum Antrieb eines weiteren Körpers durch die Kontaktelemente versetzbar ist.

WO 02/099 844 zeigt einen Antrieb, in welchem ein flächiges Piezolement einen ebenfalls flachen Resonator zu Schwingungen anregt, die in der Ebene des Resonators respektive des Piezoelementes liegen. Ein in dieser Ebene liegender, sich verjüngender Fortsatz des Resonators wird in eine oszillierende Bewegung parallel zu dieser Ebene versetzt, und übt dadurch eine Kraft auf einen weiteren Körper aus.

JP 60-074982 zeigt eine piezoelektrisch angetriebene Antriebseinheit mit einer stimmgabelartigen aktiven Einheit, zwischen deren Gabelenden gebogene Zähne angeordnet sind, welche von zwei Seiten gegen ein zwischen den. Gabeleneden angeordnetes und angetriebenes passives Element drücken. Die Einheit wirkt als Linearmotor, scheint aber nur in eine Antriebsrichtung wirken zu können.

JP 62-262676 offenbart ebenfalls einen piezoelektrischen Antrieb mit zwei Armen, zwischen denen ein angetriebenes passives Element angeordnet und angetrieben ist. Die Arme sind durch Abschnitte eines Zylindres gebildet und treiben, wenn sie oszillieren, das passive Element in einer linearen Bewegung.

SUD 773715 zeigt eine Antriebseinheit zur Bewegung eines aktiven Elements bezüglich eines passiven Elements, wobei die Antriebseinheit das aktive Element und das passive Element aufweist, das aktive Element einen Resonator und mindestens ein Anregungsmittel zur Anregung von Oszillationen des Resonators aufweist, der Resonator Kontaktbereiche zum Ausüben von Kräften auf das passive Element aufweist, und das aktive Element bezüglich des passiven Elements durch oszillierende Bewegungen der Kontaktbereiche antreibbar ist, der Resonator mindestens zwei Arme, vorzugsweise ein Paar von Armen aufweist, und die mindestens zwei Arme ausgehend von einem Verbindungsbereich des Resonators an derselben Seite des Resonators ausgebildet sind, an den äusseren Enden der Arme jeweils die Kontaktbereiche ausgebildet sind, die Kontaktbereiche durch oszillierende Bewegungen des Armpaares aufeinander zu respektive voneinander weg bewegbar sind und dabei eine Relativbewegung des passiven Elements bezüglich des aktiven Elements bewirkbar ist.

WO 03/036 786 zeigt einen Motor, bei welchem das Piezoelement auf einem zentralen Teil eines Resonators angeordnet ist und mehrere symmetrisch um den zentralen Teil angeordnete Arme mit Antriebsbereichen zum Schwingen bringt.

WO 03/079 462 zeigt einen Piezoantrieb mit Vorschubelementen, an welchen jeweils ein Knick ausgeformt ist, wodurch sie zwei Eigenfrequenzen aufweisen. Je nach der Anregungsfrequenz schwingt ein Kontaktbereich eines Vorschubelementes entlang einer elliptischen Bahn in die eine oder andere Richtung und wirkt eine entsprechend gerichtete Kraft auf einen weiteren Körper aus. Die Anregung der Schwingungen geschieht durch ein flaches Piezolelement, und die Bewegung der Kontaktbereiche verläuft parallel zu dieser Anregungsebene.

US 6,690,101 beschreibt einen Piezoantrieb, bei welchem ein Stapel von Piezoelementen im Resonator durch Einklemmen gehalten ist. Es werden weitere Elemente benötigt, um den Resonator mit einem Antriebsbereich bezüglich eines anzutreibenden Körpers zu positionieren.

US 6,323,578 offenbart einen Piezoantrieb, bei welchem mehrere Arme mit Antriebsbereichen in tangentialer Richtung auf die Oberfläche einer drehbaren Scheibe wirken. Die Arme weisen jeweils Piezoelemente auf, die eine Bewegung der jeweiligen Armspitze (mit einem Antriebsbereich) senkrecht zur Ebene des Piezoelementes verursachen.

### DARSTELLUNG DER ERFINDUNG

Es ist Aufgabe der Erfindung, einen Antrieb der eingangs genannten Art zu schaffen, welcher einen einfachen konstruktiven Aufbau aufweist.

Eine weitere Aufgabe der Erfindung ist, einen Antrieb zu schaffen, welcher sich besonders gut zur Miniaturisierung eignet.

Eine weitere Aufgabe der Erfindung ist, einen Antrieb zu schaffen, welcher für Linearantriebe mit sowohl kurzen als auch beliebig langen, quasi endlosen Hüben geeignet ist.

Eine weitere Aufgabe der Erfindung ist, einen Antrieb zu schaffen, welcher kombinierte und/oder abwechslungsweise lineare und rotatorische Bewegungen ermöglicht.

Eine weitere Aufgabe der Erfindung ist, einen Antrieb zu schaffen, welcher eine fertigungstechnisch günstige Konstruktion zulässt.

Eine weitere Aufgabe der Erfindung ist, einen Antrieb zu schaffen, welcher eine zuverlässig Kontaktierung und Kraftübertragung durch mindestens zwei, vorzugsweise vier Kontaktbereiche zulässt.

Eine weitere Aufgabe der Erfindung ist, einen Antrieb zu schaffen, welcher einen einfachen Ausgleich von Fertigungsungenauigkeiten beim Antrieb oder den angetriebenen Teilen zulässt.

Diese Aufgaben lösen eine Antriebseinheit und eine Positionierungseinheit zur Positionierung eines optischen Elementes mit den Merkmalen der entsprechenden unabhängigen Patentansprüche.

Der erfindungsgemässe Antrieb weist also einen Resonator auf, der mindestens zwei Arme, vorzugsweise ein Paar von Armen aufweist, wobei die mindestens zwei Arme, ausgehend von einem Verbindungsbereich des Resonators, an derselben Seite des Resonators ausgebildet sind. An den äusseren Enden der Arme sind jeweils die Kontaktbereiche ausgebildet, wobei die Kontaktbereiche durch oszillierende Bewegungen des Armpaares aufeinander zu respektive voneinander weg bewegbar sind, wodurch eine Relativbewegung des passiven Elements bezüglich des aktiven Elements bewirkbar ist.

Dabei ist das passive Element in sich federnd ausgebildet. Das heisst, dass ein erstes Element des passiven Elements, welches einen Kontaktbereich eines ersten Armes des aktiven Elements kontaktiert, und ein zweites Element des passiven Elements, welches einen Kontaktbereich eines zweites Armes des aktiven Elements kontaktiert, gegeneinander federnd angeordnet sind. Damit wird die Kontaktierung der Kontaktbereiche verbessert, und werden Abnutzungen der Kontaktbereiche und der genannten Elemente am passiven Element ausgeglichen.

Das aktive Elements ist vorzugsweise dergestalt, dass die beiden Kontaktbereiche eines Armpaares stimmgabelartig geformt sind und einen Teil des passiven Elements umschliessen respektive durch einen Teil des passiven Elements umschlossen sind. Im Ruhezustand weisen die Arme vorzugsweise eine Vorspannung bezüglich des passiven Elements auf und halten dieses somit fest. Vorzugsweise sind die Arme eines Armpaares symmetrisch bezüglich des passiven Elements angeordnet

Die oszillierenden Bewegungen des Armpaares entsprechen vorzugsweise einem Grundschwingungsmodus der Arme, wobei der Grundschwingungsmodus die niedrigste Frequenz der verschiedenen Schwingungsmodi des aktiven Elements aufweist.

Wenn das passive Element festgehalten wird, so bildet das aktive Element einen translatorisch und/oder rotatorisch bewegbaren Läufer. Wenn dabei die Kontaktbereiche eines Armpaares einen Teil des passiven Elements umschliessen, so wird der Läufer als Aussenläufer bezeichnet. Wenn hingegen die Kontaktbereiche eines Armpaares durch einen Teil des passiven Elements umschlossen sind, so wird der Läufer als Innenläufer bezeichnet. Umgekehrt kann natürlich auch das aktive Element bezüglich eines Bezugssystems als fest, und das passive Element als beweglich betrachtet werden.

Der Resonator weist flächige Abschnitte auf. Einzelne dieser Abschnitte sind dicker ausgebildet und/oder sind mit einem vorzugsweise ebenfalls flächigen Anregungsmittel bestückt, und sind dadurch steifer als andere Abschnitte. Dadurch können diese anderen Abschnitte als Biege- respektive Federbereiche wirken. Ein Arm ist vorzugsweise jeweils über einen solchen Federbereich mit dem Rest des Resonators verbunden. Der Federbereich und die angrenzenden Abschnitte des Armes sind vorzugsweise einstückig geformt, der Federbereich ist also integriert am Arm respektive am Resonator ausgebildet. Der Federbereich erstreckt sich entlang einer geraden Begrenzung eines anschliessenden flachen Abschnitts. Die Richtung dieser geraden Begrenzung entspricht einer bevorzugten Biegeachse des Federbereiches. Entsprechend dieser Biegeachse wird also der Arm einen bevorzugten Grundschwingungsmodus aufweisen, bei welchem einzelne Materialpunkte des Armes sich jeweils in einer Ebene (im Folgenden Grundschwingungsebene genannt) bewegen, welche sowohl senkrecht zur Ebene des Armes respektive seines flachen Abschnittes, als auch senkrecht zur Biegeachse liegt. Die äusseren Enden des Armes schwingen dabei also aufeinander zu und voneinander weg. Eine natürliche Frequenz oder Grundfrequenz entsprechend diesem Modus ergibt sich aus der Steifigkeit des Federbereiches und der Massenverteilung am schwingenden Teil des Armes. Die Grundfrequenz des Armes als ganzem ist - über alle Schwingungsmodi betrachtet - die tiefste Frequenz, mit welcher der Arm schwingen kann. Dem entspricht die Grundschwingung, die bei flachen Armen typischerweise eine Biegeschwingung ist.

Die Grundschwingungsebenen liegen typischerweise entweder parallel oder aber im Winkel zu einer Ebene eines Anregungsmittels, vorzugsweise senkrecht dazu, wie aus dem Folgenden ersichtlich wird:

Zur Anregung der Oszillationen des Resonators sind eine oder mehrere der flachen Abschnitte mit Anregungsmitteln versehen. Es kann jeweils an beiden Armen eines Armpaares ein jeweils eigenes Anregungsmittel angebracht sein, oder es kann nur ein einziges Anregungsmittel am Resonator angebracht sein, vorzugsweise an einem Verbindungsbereich zwischen zwei Armen.

Die Anregungsmittel sind in einer bevorzugten Ausführungsform der Erfindung Piezoelemente, oder aber aus einem magnetostriktiven Material. Die Anregungsmittel sind vorzugsweise im Wesentlichen flach, insbesondere eben, und sind jeweils auf einen ebenfalls flachen respektive ebenen Bereich des Resonators angebracht, beispielsweise durch Kleben, Anwachsen von Piezokristallen oder durch Ligatechnik. Die Anregungsmittel sind derart konfiguriert, dass sie Bewegungen parallel zu ihrer Ebene anregen. Durch das Zusammenwirken mit dem Resonator, insbesondere an einer Verbindungsfläche wie dem flachen Abschnitt, wird dabei eine Biegung der beiden Elemente, also des Anregungsmittels und des flachen Abschnitts, bewirkt. Die beiden Elemente bilden einen bimorphen Erreger, also einen aus zwei Elementen mit unterschiedlichen Materialeigenschaften - zum Beispiel Piezo-Element und Nicht-Piezo-Element - bestehenden Erreger.

Je nach Steifigkeit und Masse des Anregungsmittels ändern sich die Schwingungseigenschaften des Systems Resonator-Anregungsmittel gegenüber dem Resonator alleine. Einen weiteren Einfluss hat die Interaktion mit dem passiven Element: Je nach Härte, Vorspannung, Reibkoeffizient, Oberflächengüte etc. wird eine freie Schwingung gedämpft. Grundsätzlich ist die natürliche Frequenz des aktiven Elementes mit Kontakt mit einem passiven Element leicht höher als bei ungedämpfter Schwingung.

In einer bevorzugten Ausführungsform der Erfindung ist ein auf einem Arm oder Schenkel befestigtes Piezoelement ein Monolayer- oder ein Multilayer-Element, welches im d31-Modus betrieben wird. Dabei liegt eine Polarisationsrichtung des Piezoelements senkrecht zur Ebene des Armes respektive seines flachen Abschnitts, und verlaufen Elektroden am Piezoelement parallel zur Ebene des Armes. Im d31-Modus (auch Transversalmodus genannt) liegt die Hauptbewegungsrichtung des Piezoelementes senkrecht zur Richtung der angelegten Spannung. Umgekehrt können auch eines oder mehrere aneinander geschichtete Elemente im d33-Modus-betrieben werden, wobei die Polarisationsrichtung parallel zur Ebene des Armes und die Elektroden senkrecht zur Ebene des Armes verlaufen. Im d33-Modus (auch Longitudinalmodus genannt) liegt die Hauptbewegungsrichtung des Piezoelementes parallel zur Richtung der angelegten Spannung. In beiden Fällen verkürzt respektive verlängert sich das Piezoelement beim Anlegen einer Wechselspannung, biegt und/oder verlängert und/oder tordiert dabei den Arm am entsprechenden ebenen Abschnitt und bringt den Arm oder den Resonator als Ganzes zum Schwingen.

Grundsätzlich kann in allen Ausführungsformen ein einzelner Piezokristall durch einen Multilayer-Piezo ersetzt werden. Damit kann mit kleineren Spannungen gearbeitet werden, jedoch sind Multilayer-Piezos aufwendiger herzustellen und dadurch kostspieliger.

Die Arme weisen vorzugsweise am freien Ende jeweils eine asymmetrische Massenverteilung auf, beispielsweise indem der Arm zum passiven Element hin gebogen ist, oder einen hervorstehenden Ansatz in Richtung zum passiven Element hin aufweist. Beim Strecken des Armes wird durch die Beschleunigung dieser asymmetrischen, ausserhalb der Ebene, an welche das Piezoelement angebracht ist, liegenden Masse, diese Masse auch zum passiven Element hin respektive von diesem weg bewegt. Diese Bewegung überlagert sich der oben beschriebenen Biegebewegung respektive dem Bimorph-Effekt.

Es entstehen bei kontinuierlicher Anregung des Anregungsmittels Schwingungen am Ende des Armes sowohl parallel als auch senkrecht zur Ebene des Armes. Je nach Frequenz der Anregung weisen diese Schwingungen unterschiedliche Phasenlagen zueinander auf. Je nach Phasenlage führt, im Betrieb ohne das passive Element, das Ende des Armes und insbesondere ein Kontaktbereich am Ende des Armes eine annähernd elliptische Bewegung mit einer positiven oder negativen Drehrichtung aus. Beim Vorhandensein des passiven Elements ist die elliptische Bewegung durch das passive Element begrenzt, und das passive Element wird je nach Anregungsfrequenz in die eine oder andere Richtung angetrieben. Eine Amplitude der Bewegung liegt beispielsweise im Bereich unter einem Mikrometer oder unter 0.1 Mikrometer.

Die Beschreibung der Bewegung als elliptisch ist in der Regel eine Vereinfachung: unterschiedliche Materialpunkte der Kontaktbereiche bewegen sich entlang verschiedener Trajektorien, die zum Beispiel auch nierenförmig verlaufen können. Beim Kontakt mit dem passiven Element kann eine Trajektorie unstetige Abschnitte aufweisen, bei denen die Kontaktbereiche das passive Element schieben oder mehrmals gegen das passive Element schlagen.

Aufgrund von weiteren Asymmetrien des Resonators in sich, aufgrund der gegenseitigen Anordnung von Resonator(en) und Anregungsmitteln, und/oder aufgrund der Interaktion mit weiteren Teilen verläuft die Schwingung oftmals auch nicht exakt in einer Ebene. Es ist also eine dreidimensionale Bewegung einzelner Materialpunkte, und die ungefähr elliptische Bewegung wird bei der Projektion auf eine Ebene durch eine Tangente an eine gewünschte Bewegung im Bereich der Kontaktierung sichtbar. Meist ist die gewünschte Bewegung durch eine Führung des passiven Elements bezüglich des aktiven Elements vorgegeben. Mechanisch wirksam werden jeweils die Bewegungskomponenten (vektoriell gesehen), welche beim Kontakt der Kontaktbereiche mit dem passiven Element in eine zulässige Richtung entsprechend der Führung verlaufen.

Es wird also eine Kraftwirkung ausserhalb der Armebenen erzeugt. Deshalb ist es möglich, die flachen Abschnitte eines Armpaares und damit auch die entsprechenden Anregungsmittel parallel zueinander anzuordnen. Damit ist ein sehr platzsparender Aufbau möglich.

In einem Ruhezustand üben die Kontaktbereiche eines Armpaares einander entgegenwirkende Vorspannkräfte bezüglich des passiven Elements aus und halten dadurch das passive Element fest. Es liegt dabei ein Kraftschluss über das passives und das aktive Element vor, an dem keine weiteren Teile oder Halterungen beteiligt sind: Die Kräfte und Momente zwischen dem Resonator und dem passiven Element heben sich im Stillstand gegenseitig auf.

In weiteren bevorzugten Ausführungsformen der Erfindung sind der Resonator und/oder die Anregungsmittel derart ausgebildet, dass nicht nur Schwingungen in den Grundschwingungsebenen, wie oben beschrieben, angeregt werden können, sondern auch Schwingungen, die annähernd senkrecht dazu verlaufen. Dies geschieht durch Ausbildung von asymmetrischen Merkmalen innerhalb der Ebene jeweils eines Armes beispielsweise indem
- mehrere Anregungsmitteln nebeneinander auf demselben flachen Abschnitt angeordnet sind und verschieden angesteuert werden, und/oder
- der Arm mindestens einen seitlichen Einschnitt aufweist, also mit einer Schnittebene senkrecht zur Armebene und quer zur Längsrichtung des Armes, und/oder
- der Arm in der Ebene des Armes, also bei Betrachtung senkrecht auf die Ebene des Armes, im Bereich des freien Endes des Armes eine asymmetrische Einbuchtung und/oder einen asymmetrischen Ansatz aufweist.

Jede dieser Massnahmen führt dazu, dass bei geeigneter Anregungsfrequenz die Bewegung des freien Endes des Armes auch Komponenten in Richtung senkrecht zur Grundschwingungsebene aufweist. Bei entsprechender symmetrischer Gestaltung von zwei gegenüberliegenden Armen eines Armpaares führen die beiden Kontaktbereiche im Wesentlichen symmetrisch zueinander oszillierende Bewegungen aus. Durch die beschriebene Bewegung der Kontaktbereiche kann das passive Element bezüglich des Armpaares respektive des aktiven Elementes in eine Drehung um seine Achse versetz werden. Dabei heben sich Kraftkomponenten in einer Ebene orthogonal zur Bewegungsachse nicht auf, sondern Kraftkomponenten in einer Ebene orthogonal zur Bewegungsachse nicht auf, sondern verstärken die Bewegung.

In einer vereinfachten Variante der eben beschriebenen Ausführungsform weist das aktive Element zwei flache, beispielsweise rechteckförmige Arme auf, die parallel zueinander und an gegenüberliegenden Seiten eines vorzugsweise flachen Anregungsmittels befestigt sind. Das Anregungsmittel ist zur Erzeugung von Schwingungen im Wesentlichen parallel zu der Ebene der Arme angeordnet. Beispielsweise wird dazu eine Piezoelement über die Verbindungsflächen zu den Armen gespeist und im d31-Modus betrieben, so dass es hauptsächlich parallel zu diesen Verbindungsflächen schwingt. Es werden dadurch vor allem Schwingungen in der Armebene angeregt. Aber auch wenn keine, wie oben beschrieben, speziell ausgelegten Asymmetrien vorliegen, so treten auch Schwingungen senkrecht zur Armebene auf. Durch systematisches Variieren der Anregungsfrequenz lässt sich experimentell oder durch rechnerische Analyse mittels FEM-Modellen eine Kombination von Schwingungsmodi finden, welche eine resultierende Antriebskraft auf ein passives Element bewirkt, die parallel zur Ebene der beiden Arme liegt. Diese Bewegung kann, je nach Frequenz, in einer solchen Ebene in der Hauptausdehnungsrichtung der Arme, aber auch senkrecht oder im Winkel zur Hauptausdehnungsrichtung liegen. Durch geeignete Wahl der Anregungsfrequenz können bei einer wie oben beschriebenen Annkonstruktion verschiedene Schwingungsmodi angeregt werden. Je nach Schwingungsmodus
- verstärken sich die translatorisch wirksamen Bewegungen der Arme, respektive entsprechende Kräfte auf das passive Element, und heben sich die rotatorisch wirkenden Kräfte momentan oder im zeitlichen Mittel auf, oder
- verstärken sich die rotatorisch wirksamen Bewegungen der Arme, und heben sich die translatorisch wirkenden Kräfte momentan oder im zeitlichen Mittel auf, oder
- verstärken sich sowohl die translatorisch als auch die rotatorisch wirksamen Bewegungen der Arme, oder
- üben die Arme momentan oder, im zeitlichen Mittel weder eine translatorisch noch eine rotatorisch wirksame Gesamtkraft aus.

Entsprechend entsteht eine translatorische oder eine rotatorische oder eine kombinierte, schraubenartige Bewegung. Im letzten Fall sind das passive und das aktive Element lose gegeneinander bewegbar.

In bevorzugten Ausführungsformen der Erfindung füllt eine Hauptachse des passiven Elements mit der Symmetrieachse des aktiven Elements zusammen. Vorzugsweise weist ferner das aktive Element in einem Verbindungsbereich zwischen den mindestens zwei Armen einen Durchbruch respektive eine Öffnung zur Aufnahme des passiven Elements auf. Das aktive Element ist somit einerseits durch diese Öffnung und anderseits durch die Kontaktbereiche mindestens eines Armpaares bezüglich des passiven Elements gelagert, und es sind keine weiteren Lagerelemente, Führungselement oder Halterungselemente erforderlich.

In einer weiteren Gruppe von bevorzugten Ausführungsformen der Erfindung sind die Ebenen der Arme im Wesentlichen parallel zueinander und zum Anregungsmittel. Vorzugsweise verlaufen auch die für den Antrieb wirksamen . Bewegungskomponenten von Schwingungen der Kontaktbereiche im Wesentlichen in einer Ebene parallel zur Ebene der Arme. Damit ist eine besonders flache Ausführung möglich und kann der Resonator vorzugsweise aus einem einzigen flachen oder gebogenen Teil, beispielsweise einem ausgestanzten Blechstück bestehen. In dieser Ausführungsform der Erfindung verläuft eine Bewegungsachse der Relativbewegung zwischen dem aktiven Element und dem passiven Element parallel zu der genannten Ebene der Arme und vorzugsweise auch des Verbindungsbereichs.

Es können aber die für den Antrieb wirksamen Bewegungskomponenten von Schwingungen der Kontaktbereiche im Wesentlichen auch in einer Ebene senkrecht zur Ebene der Arme verlaufen. Eine weitere bevorzugte Ausführungsform der Erfindung weist deshalb ein passives Element auf, dessen Bewegungsrichtung im Wesentlichen senkrecht zur Hauptausdehnungsrichtung von zwei länglichen, flachen Armen des aktiven Elements verläuft, und im Winkel zu, vorzugsweise zumindest annähernd senkrecht zu den Armebenen verläuft. Auch hier ist vorzugsweise der Resonator aus einem flachen Blech gebildet und liegen ein Armpaar respektive die Armebene und der Verbindungsbereich in derselben Ebene.

Der Resonator wird vorzugsweise einstückig und durch beispielsweise Fräsen, Elektroerodieren, Formstanzen und Biegen, Formsintern von Pulvermaterial, etc. hergestellt. Als Material für den Resonator wird vorzugsweise ein Metall gewählt, beispielsweise Stahl, Aluminium, Titan, Phosphorbronze, Berylliumkupfer etc., oder ein keramischer Werkstoff. Ein metallischer Resonator ist vorzugsweise an den Kontaktbereichen mit einer keramischen Hartschicht versehen, beispielsweise aus einem Titaniumnitrid, oder mit einem keramischen Körper bestückt.

Das Resonatormaterial wird gemäss den folgenden Kriterien gewählt:
- Hoher Q-Faktor, d.h. wenig innere Dämpfung.
- Guter Kopplungsfaktor, damit die dynamische Energie des Piezos auf dem Schwinger übertragen werden kann.
- Elektrisch leitend, da der Resonator in der Regel als elektrischer Anschluss für ein oder mehrere Piezoelemente dient.
- Idealer Reibpartner zum passiven Element
- Industriell formbar
- Kostengünstig

Das passive Element ist vorzugsweise aus einem der genannten Materialien hergestellt. Es kann aber, da es nicht bestimmte Schwingungseigenschaften aufweisen muss, auch aus Kunststoff oder einem Kunststoffkompositwerkstoff bestehen, beispielsweise aus einem mit Glas oder Keramik versetzten Kunststoff.

Die Anforderungen an das passive Material sind die Folgenden:
- Idealer Reibpartner zum Resonator, das heisst, maximaler Reibungskoeffizient mit minimalem Abrieb.
- Optimale Dämpfung des Resonators am Berührungspunkt, damit die elliptische Bewegung in einen Vortrieb umgesetzt werden kann.

Die Oberfläche des passiven Elements wie auch des aktiven Elements ist vorzugsweise gehärtet durch beispielsweise Rollen, Nitrieren, Vergüten etc.. Vorzugsweise ist die Oberfläche des flächenmässig grösseren Kontaktpartners, typischerweise des passiven Elements, poliert, wohingegen die Oberfläche des flächenmässig kleineren Kontaktpartners, typischerweise des aktiven Elements aufgerauht oder strukturiert ist.

Der Resonator des erfindungsgemässen Antriebs ist in einer anderen bevorzugten Ausführungsform der Erfindung aus einem flächigen Blechstück durch Formstanzen und Biegen hergestellt. Dazu werden beispielsweise zwei Enden eines einzigen länglichen Blechstücks gegeneinander gebogen, so dass sie parallel verlaufen und ein Armpaar bilden. Vorzugsweise sind seitlich an den Armen hervorstehende Laschen zum jeweils gegenüberliegenden Arm hin gebogen und mit diesem verbunden. Damit ist eine Versteifung des Armpaares im Verbindungsbereich ohne weitere Teile erreichbar. In einer anderen Variante der Erfindung sind zwei im Wesentlichen symmetrische Blechteile zu flachen, in dieselbe Richtung und stellenweise parallel zueinander verlaufenden Armen gebogen und im Verbindungsbereich unmittelbar aneinander oder an einem dritten Körper befestigt.

In einer bevorzugten Ausführungsform der Erfindung weist der Antrieb ein Armpaar auf welches auf das passive Element wirkt, und weist der Resonator mindestens einen flachen Abschnitt auf, wobei das mindestens eine Anregungsmittel auf dem mindestens einen flachen Abschnitt angebracht ist, das mindestens eine Anregungsmittel entsprechend seiner Flächigkeit eine Ebene des mindestens einen Anregungsmittels definiert, und die Arme ebenfalls flächig geformt sind und die Fläche der Arme im Wesentlichen parallel zum flachen Abschnitt und zum Anregungsmittel verläuft.

Damit ist es möglich, einen extrem flachen Linearantrieb zu bilden, wobei die Bewegungsrichtungen des passiven Elements in der Ebene der Fläche des Antriebs, senkrecht oder im Winkel zu dieser Fläche liegen können.

In einer anderen bevorzugten Ausführungsform der Erfindung weist der Antrieb ein Armpaar auf welches auf das passive Element wirkt und weist der Resonator mindestens einen flachen Abschnitt auf, wobei das mindestens eine Anregungsmittel auf dem mindestens einen flachen Abschnitt angebracht ist, das mindestens eine Anregungsmittel entsprechend seiner Flächigkeit eine Ebene des mindestens einen Anregungsmittels definiert, und wobei antriebswirksame Komponenten einer Bewegung von einzelnen Materialpunkten der Kontaktbereiche im Wesentlichen parallel zum flachen Abschnitt und zum Anregungsmittel verlaufen.

Damit ist es möglich, einen flachen Linearantrieb mit begrenztem Hub, dessen Bewegungsrichtung in der Ebene der Fläche des Antriebs liegt, zu bilden.

In einer anderen bevorzugten Ausführungsform der Erfindung weist der Antrieb ein Armpaar auf welches auf das passive Element wirkt und weist der Resonator mindestens einen flachen Abschnitt auf, wobei das mindestens eine Anregungsmittel auf dem mindestens einen flachen Abschnitt angebracht ist, das mindestens eine Anregungsmittel entsprechend seiner Flächigkeit eine Ebene des mindestens einen Anregungsmittels definiert, und wobei antriebswirksame Komponenten einer Bewegung von einzelnen Materialpunkten der Kontaktbereiche im Winkel, insbesondere senkrecht, zu einer Ebene des flachen Abschnitts respektive des Anregungsmittels verlaufen.

Damit ist es möglich, einen flachen Linearantrieb mit extrem einfachem Aufbau und mit im Wesentlichen unbegrenztem Hub zu bilden.
In einer anderen bevorzugten Ausführungsform der Erfindung weist der Antrieb mindestens zwei über das passive Element gegeneinander wirkende Arme auf, wobei der Resonator aus einem einzigen flachen oder stellenweise gekrümmten Teil mit im Wesentlichen gleichbleibender Dicke gebildet ist.

Damit ist es möglich, einen flachen Antrieb mit extrem einfachem Aufbau zu bilden, bei dem der Resonator beispielsweise aus einem einzigen ausgestanzten Blechstück besteht, auf welchem das Anregungsmittel angebracht ist und welches das passive Element umfasst und/oder von diesem umfasst wird.

In einer bevorzugten Variante der vorgenannten Ausführungsformen sind das passive Element und das aktive Element über einen Grundkörper und einen angetriebenen Körper federnd miteinander verbunden. Das passive Element ist also als Ganzes gegenüber dem aktiven Element federnd angeordnet. Durch diese federnde Verbindung können Ungenauigkeiten in der Herstellung, oder Verschiebungen zwischen dem Grundkörper und dem angetriebenen Körper im Betrieb ausgeglichen werden. Die federnde Verbindung kann am aktiven Element oder am passiven Element oder an beiden ausgebildet sein, und ist vorzugsweise einstückig mit einem Teil derselben geformt.

Die federnde Aufhängung des aktiven Elements führt vom grundkörper vorzugsweise zu einem Schwingungsknoten von im Betrieb verwendeten Schwingungsmodi des Resonators, so dass die Schwingung ungehindert und mit wenig Energieverlust möglich ist. Der Bereich, an welchem die Aufhängung mit dem Resonator verbunden ist, liegt beispielsweise bei der Mitte der Fläche des Anregungsmittels oder bei der Mitte einer Seite des Anregungsmittels.

Bei der Aufhängung im Bereich der Mitte des Anregungsmittels besteht die Aufhängung vorzugsweise aus einem Abschnitt des Resonatorbleches, welches aus der Ebene des Resonators herausgebogen ist und zu einem Basiselement zur Befestigung am Grundkörper führt. Das Basiselement, die Aufhängung und der Resonator sind also vorzugsweise einstückig ausgebildet.

In einer weiteren bevorzugten Ausführungsform der Erfindung weist das passive Element bezüglich einer Bewegung im Bereich der Kontaktbereiche innerhalb der Ebene des Resonators und im Wesentlichen senkrecht zur Bewegungsachse eine über 100 oder über 1000 mal kleinere Federkonstante als der Resonator auf.

Das passive Element ist einstückig ausgebildet, oder aber vorzugsweise mehrteilig. Dabei weist es mindestens zwei Kontaktelemente zur Übertragung von Antriebskräften von den Kontaktbereichen auf den angetriebenen Körper auf, sowie mindestens ein Federelement, welches die Kontaktelemente in entgegengesetzte Richtungen gegen die Kontaktbereiche drückt.

In einer weiteren bevorzugten Ausführungsform der Erfindung ist das passive Element federnd mit dem angetriebenen Körper verbunden, und ist vorzugsweise diese federnde Verbindung einstückig mit einer Kontaktplatte des passiven Elements zur Aufnahme von Antriebskräften geformt. Vorzugsweise ist dabei die federnde Verbindung in einer Richtung zur Übertragung von Antriebskräften starr und in dazu orthogonalen Richtungen nachgiebig. Damit können auch in diesem Bereich Ungenauigkeiten kompensiert werden und ist durch die selektive Steifheit der Verbindung gleichwohl eine präzise Bewegungsübertragung auf den angetriebenen Körper möglich. Zur Vermeidung von Schäden bei Schlägen weisen der angetriebene Körper und/oder weitere Elemente des Antriebs eine Begrenzung von Bewegungen der federnden Verbindung auf.

Die Bewegungsrichtung der Relativbewegung zwischen dem aktiven und dem passiven Element muss nicht zwingend in Richtung der Ebene der Bleche erfolgen, sondern kann auch im Winkel zu dieser Ebene oder sogar senkrecht dazu verlaufen. Vorzugsweise ist eine Bewegung des passiven Elements durch Führungsmittel auf eine vorgegebene translatorische oder rotatorische Dimension eingeschränkt. Die Bewegungsrichtung ist also durch die Führungsmittel eingeschränkt respektive vorgegeben. Es tragen jeweils diejenigen Bewegungskomponenten des aktiven Elements im Kontaktbereich zur Bewegung bei, die entlang der vorgegebenen Dimension verlaufen.

In weiteren bevorzugten Ausführungsformen der Erfindung weist der Antrieb mindestens zwei Resonatoren mit mindestens zwei nebeneinander, vorzugsweise parallel zueinander angeordneten Armpaaren auf, welche auf dasselbe passive Element wirken. Damit kann eine höhere Antriebskraft erzielt und eine bessere Zuverlässigkeit des Antriebs gewährleistet werden. Vorzugsweise ist mindestens ein flaches Anregungsmittel, zwischen zwei parallel zueinander angeordneten Resonatoren zur Anregung von Schwingungen der beiden Resonatoren angeordnet. Mindestens einer der Resonatoren weist vorzugsweise eine elektrisch leitende Aufhängung zur elektrischen Kontaktierung des Anregungsmittels mit mindestens einem Basiselement auf. Die leitende Aufhängung und der Resonator sind vorzugsweise einstückig ausgebildet. Damit ist ein einfacher Sandwich-artiger Aufbau des aktiven Elements möglich, und können Anschlussdrähte und deren Bonding dank der leitenden Aufhängung(en) eliminiert werden, da die Konkaktierung an einer nicht bewegten Stelle des Resonatorbleches geschieht.

Vorzugsweise weist der Antrieb mindestens eine Zwischenelektrode zur elektrischen Kontaktierung des Anregungsmittels auf, wobei zwischen jeweils zwei der Resonatoren mindestens zwei Anregungsmittel, und jeweils zwischen zwei Anregungsmitteln eine Zwischenelektrode angeordnet sind. Damit ist es möglich, die mindestens zwei Resonatoren auf demselben elektrischen Potential zu betreiben, so dass elektrisch leitende passive Elemente verwendbar sind. Andernfalls besteht das passive Element aus einem elektrisch isolierenden Material und sind die mindestens zwei Resonatoren elektrisch voneinander isoliert.

Zur elektrischen Kontaktierung zwischen zwei der Resonatoren ist vorzugsweise jedem der Resonatoren ein Basiselement aus Metallblech zugeordnet oder einstückig angeformt, und ist mindestens eines der Basiselemente zur elektrischen Kontaktierung eines anderen Basiselements auf dieses hin gebogen ist.

Bei der Verwendung von zwei oder mehr parallel angeordneten und jeweils über ein Armpaar wirkende Resonatoren sind die folgenden Ausführungsformen von passiven Elementen bevorzugt:

Vorzugsweise weist das passive Element mindestens zwei Kontaktplatten auf, wobei jede der Kontaktplatten durch Kontaktbereiche von nebeneinander liegenden Armen antreibbar ist. Vorzugsweise sind die beiden Kontaktplatten durch ein Federelement gegen die Kontaktbereiche gedrückt, und sind die Kontaktplatten durch das Federelement zum Ausgleich von Ungenauigkeiten verdrehbar.

Da das passive Element zwischen den Armen des aktiven Elements angeordnet ist, zieht die Feder beispielsweise Kontaktplatten der Kontaktelemente auseinander. Die Angriffspunkte der Federkraft liegen, in Bewegungsrichtung gesehen, in der Mitte der Kontaktplatten. Die Kontaktplatten sind dabei auch um eine Achse parallel zur Bewegungsrichtung drehbar, wofür die Haltearme bezüglich dieser Drehung eine geringe Steifigkeit aufweisen. Somit werden die beiden Kontaktplatten an beiden Seiten gegen die Kontaktbereiche der beiden Resonatoren gedrückt, und es findet ein Kontakt an allen vier Kontaktbereichen statt. Dadurch verbessert sich die mechanische Kontaktierung, und mit ihr die Antriebskraft und Lebensdauer des Antriebs.

Eine andere Variante zur Verbesserung der Kontaktierung der Kontaktbereiche besteht darin, dass die Kontaktplatten um eine Achse senkrecht zur Verbindungslinie zwischen den Kontaktbereichen, welche diese Kontaktplatte kontaktieren, nach aussen oder nach innen gebogen sind. Dadurch ergibt sich eine selbstzentrierende und ausgleichende Bewegung der Kontaktplatten bezüglich der Kontaktbereiche.

Die Herstellung eines Antriebes gemäss der Erfindung ist durch die Verwendung von mehrheitlich flachen Teilen sehr einfach: es müssen im Wesentlichen die flachen Komponenten aufeinander gestapelt und verbunden werden. Die Verbindung kann meist eine elektrisch leitende sein: entweder werden Teile verbunden, die einander elektrisch galvanisch kontaktieren sollen, oder es wird ein Leiter mit einem Isolator verbunden, wobei nur die mechanische Befestigung von Interesse ist. Deshalb wird vorzugsweise ein elektrisch leitender Klebstoff verwendet werden, insbesondere einer mit anisotroper Leitfähigkeit, welcher also je nach Art der Verarbeitung nur in bestimmte Richtungen und an bestimmten Stellen leitet. Ein solcher Klebstoff ist beispielsweise ein Epoxy-Kleber mit eingelagerten Metallkugeln, vorzugsweise von normierter Grösse. Die Aushärtung des Klebers geschieht unter Druck, so dass die Nickelkugeln die zu verbindenden Leiter beiderseits kontaktieren. Durch das Schwinden des Klebers während der Aushärtung werden die Leiter permanent gegeneinander gezogen. Alternativ dazu kann auch ein leitender Klebstoff, gegebenenfalls umgeben von isolierendem Klebstoff, eingesetzt werden. Es ist auch möglich, die Resonatoren von beiden Seiten an mittiges Kunststoffteil zu kleben und/oder nieten.

Die Resonatorbleche können im Bereich der Basiselemente zueinander hin gebogen und miteinander mechanisch und auch elektrisch verbunden werden. Es ist auch möglich, die beiden Resonatoren aus einem einzigen Blech zu formen, das U-förmig um die Anregungsmittel gebogen wird, respektive in welches die Anregungsmittel eingeschoben werden.

In einer weiteren bevorzugten Ausführungsform der Erfindung wird der erste Resonator nicht vollständig ausgestanzt, sondern wird als Teil eines Stanzstreifens weiter gefördert, und werden die einzelnen Teile bei der Montage auf den Stanzstreifen gelegt, miteinander verbunden und mit dem Stanzstreifen weiterbefördert.

Zur Minimierung der Antriebsenergie und auch der benötigten Spannung ist eine Kombination der folgenden Massnahmen zu bevorzugen:
- möglichst dünne Kleberschicht zwischen Resonatoren und Piezos und Zwischenelektrode;
- möglichst gleiche Resonatoren, d.h. gleiche Form, gleiches Stanzwerkzeug, gleiches Los des Grundmaterials (Blech), so dass die Frequenzen der benutzten Schwingungsmodi für beide Resonatoren nahe beieinander liegen;
- flexibler Übergangsbereich zwischen der Zwischenelektrode und deren elektrischem Anschluss;
- Aufhängung des Resonators bei einem Schwingungsknoten von relevanten Schwingungsmodi.

Mit allen Massnahmen zusammen kann die Speisespannung für den Motor von beispielsweise 80 V auf weniger als 2.8 V und sogar weniger als 2 Volt reduziert werden. Es kann dadurch ohne Verwendung teurere Multilayerpiezos mit niedrigen Spannungen gearbeitet werden, wie sie in batteriebetriebenen Geräten vorgegeben sind.

Das Elastizitätsmodul von Klebstoff und gegebenenfalls des Kunststoff-Trägerelementes ist viel kleiner als jenes des Piezos und des Resonators aus Metall oder Keramik. Somit wirken sich diese vergleichsweise nachgiebigen Teile wenig auf die Schwingung aus, absorbieren aber Energie.
Der erfindungsgemässe Antrieb ist klein - seine Länge liegt im Bereich von 1 bis 2 Zentimetern, oder sogar noch weniger - leicht, industriell herstellbar und kostengünstig, und erlaubt ein kontrolliertes Bewegen mit sehr kleinen Mikroschritten. Ferner ist er aufgrund seines einfachen Aufbaus sehr robust.

Der erfindungsgemässe Antrieb ist für miniaturisierte Anwendungen besonders geeignet, beispielsweise als linearer Stellantrieb für optische Fokussier-, Zoom- und Blendeneinrichtungen. Grundsätzlich sind optische Anwendungen vorteilhaft, da das passive Element transparent oder hohl ausgeführt werden kann. Dies erlaubt es, die Lichtwellen direkt in der Symmetrieachse des Antriebs durchzuführen. Vorteilhaft sind beispielsweise Anwendungen mit Glasfaserkabeln, das Verstellen von Fokuspunkten, Lichtleiter für Zeiger etc.

Eine Positionierungseinheit zur Positionierung eines optischen Elementes gemäss der Erfindung weist auf: einen Grundkörper und eine dazu verschiebbare Halterung, welche Halterung das optische Element trägt, wobei die Positionierungseinheit eine Antriebseinheit gemäss der Erfindung aufweist. Vorzugsweise ist dabei das aktive Element am Grundkörper und das passive Element an der Halterung befestigt.

Weitere bevorzugte Anwendungen sind Positioniersysteme wie zum Beispiel XY-Tische, sowie Mikro-Manipulatoren zur Handhabung oder Beeinflussung kleiner Objekte.

Aufgrund seiner Robustheit wird der Antrieb auch bevorzugt im Automobilbereich eingesetzt, beispielsweise als Antrieb von Zeigern oder Lüftungsklappen.

Weitere bevorzugte Ausführungsformen gehen aus den abhängigen Patentansprüchen hervor.

### KURZE BESCHREIBUNG DER ZEICHNUNGEN

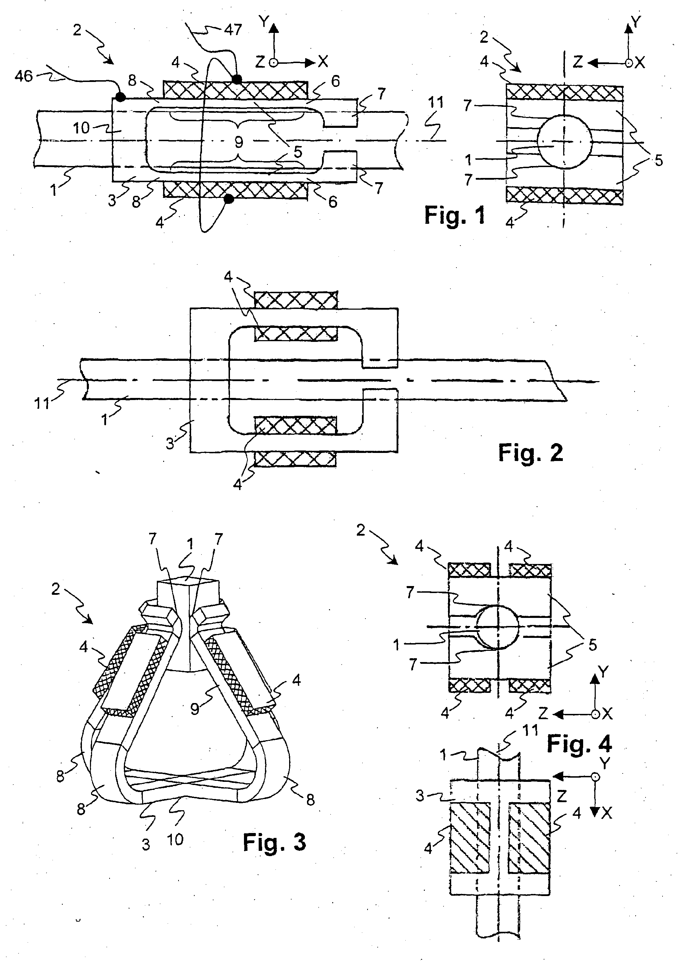

Im folgenden wird der Erfindungsgegenstand anhand von bevorzugten Ausführungsbeispielen näher erläutert. Dabei werden in den Figuren 1-29, 36 und 45-46 Antriebe gezeigt, die das erfindungsgemäße passive Element nicht enthalten, aber andere Aspekte der Erfindung erfassen und zum verständnis der Erfindung nützlich sind. Die beiliegenden Zeichnungen zeigen jeweils schematisch:
- Figur 1: einen Antrieb in einer Seitenansicht und einer Ansicht in Richtung einer Bewegungsachse;
- Figur 2: einen Antrieb mit jeweils zwei Piezoelementen je Arm;
- Figur 3: einen Antrieb mit zwei in die gleiche Richtung zeigenden Armpaaren;
- Figur 4: einen Antrieb mit je zwei in derselben Ebene nebeneinander angeordneten Piezoelementen je Arm, in einer Aufsicht und einer Ansicht in Richtung der Bewegungsachse;
- Figur 5: einen Bewegungsmodus eines Motors gemäss Figur 4 zur Anregung einer Rotationsbewegung;
- Figur 6: einen Antrieb mit einer Asymmetrie in der Ebene der Arme;
- Figur 7: einen Antrieb mit einem flachen, rechteckigen passiven Element;
- Figur 8: einen Antrieb mit einem rohrförmigen passiven Element;
- Figur 9: einen Antrieb, bei welchem das aktive Element als Innenläufer ausgebildet ist, in einer Seitenansicht und einer Ansicht in Richtung der Bewegungsachse;
- Figuren 10 bis 12: verschiedene Varianten zur Befestigung eines aktiven Elements;
- Figur 13: einen Piezomotor mit Piezoelementen im d31-Mode, und eine Kontaktierung solcher Piezoelemente;
- Figur 14: einen Piezomotor mit Piezoelementen im d33-Mode, und eine Kontaktierung solcher Piezoelemente;
- Figur 15: einen Piezomotor mit Piezoelementen im d15-Mode;
- Figuren 16 und 17: einen Piezomotor gemäss Figur 15 in verschiedenen Bewegungszuständen;
- Figur 18: eine Ausgestaltung eines passiven Elements;
- Figuren 19 und 20: vorteilhafte Ausgestaltungen eines aktiven Elements;
- Figur 21: einen Antrieb mit einem magnetostriktiven Wirkprinzip
- Figur 22: einen Antrieb mit einem einstückigen, gebogenen Resonator;
- Figur 23: einen Antrieb mit nur einem Anregungsmittel;
- Figur 24: einen Antrieb mit zwei Armpaaren, die in entgegengesetzte Richtungen zeigen;
- Figuren 25 bis 27: aktive Elemente aus gebogenen Blechteilen, jeweils in verschiedenen Ansichten;
- Figur 28: einen Antrieb mit einem senkrecht zur Symmetrieachse eines Armpaares angeordneten Zylinders als passivem Element;
- Figur 29: einen Antrieb, bei welchem das passive Element zwei gegenläufig drehbare Zylinder aufweist;
- Figuren 30 bis 32: verschiedene Schwingungsmodi eines aktiven Elements gemäss Figur 1;
- Figur 33: einen Verlauf von Antriebskräften respektive Momenten in Abhängigkeit einer Ansteuerfrequenz;
- Figur 34: ein Blockschema einer Schaltung zur Ansteuerung eines Piezomotors;
- Figur 35: eine bevorzugte Ausführungsform der Erfindung;
- Figur 36:: einen Antried mit nicht erfindungsgemäßem passiven Element;
- Figur 37: eine Positionierungseinheit gemäß der Erfindung zur Positionierung einer Linse;
- Figur 38: einen Resonator mit einstückig angeformter Aufhängung und elektrischer Kontaktierung;
- Figur 39: ein teilweise montiertes aktives Teilmodul der Positionierungseinheit;
- Figur 40: eine Explosionszeichnung des aktiven Teilmoduls;
- Figur 41: ein erfindungsgemässes passives Element;
- Figur 42: die Positionierungseinheit ohne das aktive Teilmodul;
- Figuren 43 - 44: weitere Ausführungsformen eines aktiven Teilmoduls;
- Figuren 45 - 46: Antriebe mit Aussenläufern.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### WEGE ZUR AUSFÜHRUNG DER ERFINDUNG

Figur 1 zeigt einen Antrieb in einer Seitenansicht und einer Ansicht in Richtung einer Bewegungsachse 11. Der Antrieb weist ein passives Element 1 auf, das von einem aktiven Element 2 umschlossen ist. Das aktive Element 2 weist einen Resonator 3 mit einem Armpaar 5 aus zwei Armen 6, die über einen Verbindungsbereich 10 miteinander verbunden sind. Die Arme 6 sind im Wesentlichen symmetrisch zueinander geformt, ähnlich einer Stimmgabel. Das aktive Element 2 weist ferner zwei Anregungsmittel 4 auf, von denen jeweils eines an einem flachen Abschnitt 9 eines Armes 6 befestigt ist, beispielsweise durch Kleben.

Der Klebstoff weist vorzugsweise folgende Eigenschaften auf: Gute Energieübertragung vom Piezoelement 4 an den Resonator 3, eine konstante Dicke und elektrische Leitfähigkeit, damit die verklebte Elektrode kontaktiert werden kann, zum Beispiel unter Zugabe von Silberepoxy oder von elektrisch leitenden mikroskopischen Metallkügelchen, beispielsweise aus Nickel. Ferner: schnelle Aushärtbarkeit, thermisch beständig, ermüdungsarm, gut dosierbar. Das Kleben erlaubt, Fertigungsungenauigkeiten zwischen Resonator 3 und Anregungsmittel 4 auszugleichen.

Neben der Klebetechnik gibt es auch die Möglichkeit, das keramische Piezoelement direkt auf einen Resonator aufzutragen und "wachsen" zu lassen, bis es die gewünschte Dicke erreicht hat. Dies hat den Vorteil, dass keine Klebeoperation vorgenommen werden muss, und dass keine Scherverluste in der Klebeschicht auftreten.

Andererseits kann auch Metall mit galvanotechnischen Mitteln, insbesondere durch Ligatechnik, oder durch Diffusionsbonding oder Löten am Piezoelement 4 angebracht werden.

An den freien Enden der Arme 6 befinden sich Kontaktbereiche 7. Die Kontaktbereiche 7 liegen einander bezüglich einer Symmetrieachse des Armpaares 5 gegenüber. In einem Ruhezustand ohne Anregung der Anregungsmittel 4 ist das passive Element 1 durch die Arme 6 an den Kontaktbereichen 7 eingeklemmt. Das passive Element 1 ist in dieser Ausführungsform ein Rundstab, also rotationszylindrisch geformt. Die Kontaktbereiche 7 der Arme 6 sind vorzugsweise ähnlich der Form des passiven Elements 1 geformt. Bei einem rotationszylindrischen passiven Element 1 sind die Kontaktbereiche 7 konkav und weist diese konkave Form eine schwächere Krümmung als jene des Umfangs des passiven Elements 1 auf. Das aktive Element 2 respektive der Resonator 3 weist am Verbindungsbereich 10 eine Öffnung 14 entsprechend der Form des passiven Elements 1 auf, durch welche Öffnung 14 das passive Element 1 geführt ist. Das aktive Element 2 ist somit entlang des passiven Elements 1 in Richtung der Bewegungsachse verschiebbar und auch um die Bewegungsachse drehbar.

Die Richtung der Bewegungsachse ist als X-Richtung bezeichnet, eine senkrecht dazu und senkrecht zur Schenkelebene verlaufende Richtung als Y-Richtung, und eine zur X und Y-Richtung senkrecht verlaufende Richtung als Z-Richtung.

Jeder der Arme 6 weist einen flachen, ebenen Abschnitt 9 auf, der jeweils zwischen dem Verbindungsbereich 10 und dem freien Ende des Armes 6 mit dem Kontaktbereich 7 angeordnet ist. Die flachen Abschnitte 9 erstrecken sich in der XZ-Ebene und sind parallel zueinander. Der flache Abschnitt 9 jedes Armes 6 ist über einen Federbereich 8 mit dem Verbindungsbereich 10 verbunden und damit um eine in Z-Richtung verlaufende Biegeachse bezüglich des Verbindungsbereiches 10 bewegbar. Der flache Abschnitt 9 selber ist durch das Anregungsmittel 4 versteift und deshalb vorwiegend dann wesentlich deformierbar, wenn das Anregungsmittel 4 angeregt wird. Ansonsten kann der Arm 6 im Wesentlichen am Federbereich 8 bezüglich des Verbindungsbereiches 10, schwingen. Dies entspricht einer Grundschwingung des Armes. Dabei bewegen sich einzelne Materialpunkte des Armes 6 jeweils in Ebenen , parallel zur XY-Ebene, die im Folgenden Grundschwingungsebenen genannt werden.

Die Anregungsmittel 4 sind vorzugsweise ebenfalls flach und parallel auf den entsprechenden flachen Abschnitten 9 angeordnet. Die Anregungsmittel 4 sind vorzugsweise Piezoelemente, und sind senkrecht zur Ebene des Anregungsmittels 4 respektive des entsprechenden flachen Abschnitts 9 polarisiert. Die Piezoelemente weisen elektrische Anschlüsse an den parallel zur Hauptebene des flachen Abschnitts 9 respektive des Piezoelements 4 verlaufenden Flächen auf, um im d31-Modus betrieben zu werden. Beim d31-Modus verläuft die Ausdebnungsrichtung des Piezoelementes senkrecht zum angelegten elektrischen Feld. Piezoelemente können auch als Multilayer-Elemente ausgebildet sein.

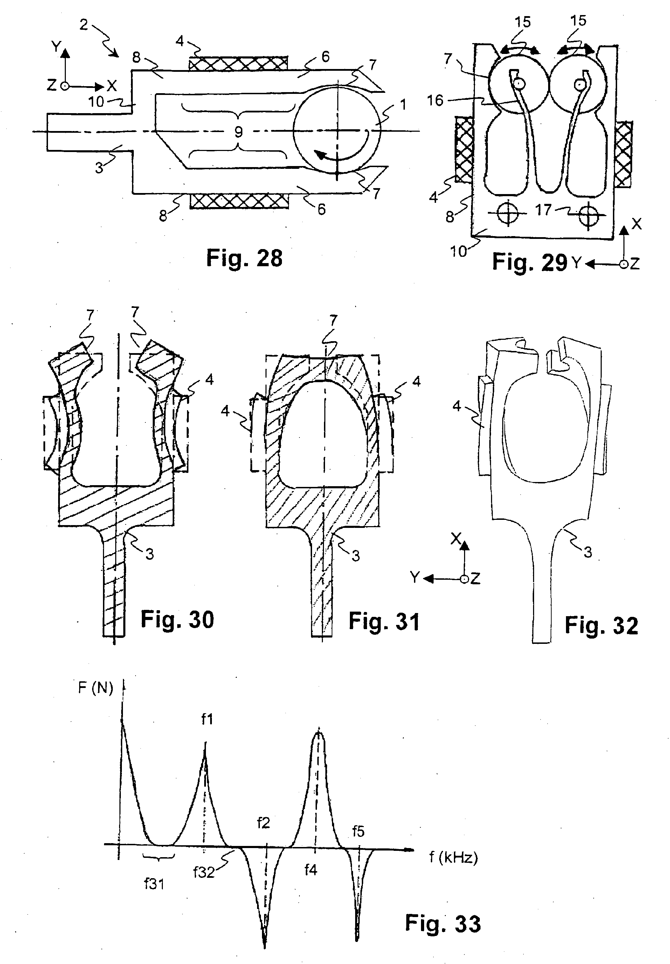

Die Piezoelemente 4 sind vorzugsweise elektrisch parallel geschaltet, wobei beispielsweise der Resonator 3 eine elektrische Verbindung zu einem gemeinsamen ersten Anschluss 46 bildet, und die aussenliegenden Elektroden der beiden Piezoelemente 4 miteinander und mit einem zweiten Anschluss 47 verbunden sind Die beiden Anschlüsse sind mit einer Treiberschaltung verbunden, wie sie in Figur 33 schematisch dargestellt und weiter unten beschrieben ist; In den weiteren Figuren sind der Klarheit halber die elektrischen Anschlussleitungen 46, 47 nicht eingezeichnet

**Figuren 30** bis **32** zeigen verschiedene Schwingungsmodi eines aktiven Elements ähnlich jenem von **Figur 1**, wobei jedoch der Verbindungsbereich 10 nicht eine Öffnung 14 sondern eine zentrale Aufhängung aufweist. In den Modi gemäss den **Figuren 30** und **31** schwingen Materialpunkte im Wesentlichen in Grundschwingungsebenen und ist deshalb eine Querschnittszeichnung zur Darstellung ausreichend. Die beweglichen Abschnitte der Arme 6 sind im Ruhezustand im flachen Abschnitt 9 jeweils in sich symmetrisch, hier also im Wesentlichen quaderförmig. An den freien Enden weist jeder der Arme 6 bezüglich des flachen, Abschnitts 9, in Z-Richtung gesehen, einen asymmetrisch geformten Abschnitt auf. Hier ist dies eine Ausformung senkrecht zur Ebene des flachen Abschnitts 9, also in Y-Richtung, welche den Kontaktbereich 7 bildet. Die Ausformung ist in den Figuren nach innen, zum passiven Element 1 hin gerichtet. Sie kann jedoch auch alternativ oder zusätzlich dazu nach aussen gerichtet sein.

Bei Verlängerung oder Verkürzung des Armes 6 in der XZ-Ebene durch Anregung des Piezoelements 4 bewirkt die Ausformung senkrecht zu dieser Ebene durch ihre Massenträgheit eine Verdrehung der Ausformung um die Z-Richtung und ein Anheben oder Andrucken des Kontaktbereiches 7 in Y-Richtung. Dieser Bewegung überlagert ist ein Bimorph-Effeld, also eine Krümmung des Armes 6 aufgrund der unterschiedlichen Ausdehnung von Piezoelement 4 und flachem Abschnitt 9.

**Figur 30** zeigt einen typischen Zustand bei einer bestimmten ersten Anregungsfrequenz. Die Arme 6 schwingen einerseits in Längsrichtung (X-Richtung) und andererseits aufeinander zu resp. voneinander weg (Y-Richtung). Je nachdem, welche der beiden Schwingungen der anderen voreilt, führen die Kontaktbereiche 7 eine beispielsweise elliptische Bewegung mit einem entsprechenden Drehsinn aus. Beim Vorliegen des passiven Elements 1 üben dadurch die Kontaktbereiche 7 eine Kraft in positiver oder negativer X-Richtung auf das passive Element 1 aus.

**Figur 31** entspricht einer zweiten Anregungsfrequenz, bei welcher die Kontaktbereiche vorwiegend in Y-Richtung schwingen und aufeinander schlagen.

Beim Vorliegen des passiven Elements 1 wird insgesamt keine Kraft auf das passive Element 1 ausgeübt, es ist also nur lose geführt und durch von aussen wirkende Kräfte bewegbar.

**Figur 32** entspricht einer dritten Anregungsfrequenz, bei welcher die Arme 6 eine Torsionsbewegung um ihre Längsrichtung, also um die X-Richtung ausführen. Die Arme sind vorzugsweise aus demselben Material, aber in Y-Richtung gesehen verschieden geformt.

Es resultiert eine Rotation von einzelnen Punkten der Kontaktbereiche 7 in der YZ-Ebene, also in der Ebene senkrecht zur Bewegungsachse. Die Richtung der Rotation ist wiederum durch Wahl der Amegungsfrequenz bestimmbar. Dabei müssen die Kontaktbereiche 7 beider Arme mit demselben Drehsinn rotieren.

beispielhafte Anregungsfrequenzen sind, für einen einstückigen Resonator 3 gemäss **Figur 30-32**, mit Dimensionen von 2.5x2.5x4.5 Millimetern, sind ca. 149 kHz (Figur 30) resp. 26 kHz (Figur 31) resp. 148 kHz (Figur 32). Grundsätzlich sind die Frequenzen von der Geometrie des Resonators 3 und von Materialdaten wie Elastizitätsmodul, Querkontraktion und Dichte abhängig. Beispielsweise kann der Resonator 3 aus Stahl gefertigt und mit Frequenzen zwischen 300 kHz und 500 kHz betrieben werden, insbesondere mit 420 kHz für eine Vorwärtsbewegung und 350 kHz für eine Rückwärtsbewegung. Oder der Resonator 3 kann aus Aluminium gefertigt und mit Frequenzen zwischen 150 kHz und 300 kHz betrieben werden, insbesondere mit 165 kHz für eine Vorwärtsbewegung und 250 kHz für eine Rückwärtsbewegung.

Die Frequenzen verschiedener Schwingungsmodi sind aufeinander abgestimmt, so dass eine gewünschte Gesamtbewegung resultiert Beim Entwurf des aktiven Elementes 2 werden beispielsweise Überlegungen wie die folgenden angestellt: Bei getrennter Betrachtung der beiden Auslenkungsrichtungen, liegen bei einem uniformen Balken einerseits Schwingungen in Längsrichtung (ohne Biegung) und andererseits reine Biegebewegungen vor. Betrachtet man die Frequenz der Längsschwingungen, so entspricht die Frequenz mit maximaler Auslenkung einem erstern Schwingungsmode. Die Amplitude und damit eine Schrittweite des Antriebs ist maximal. Bei höheren Moden nimmt, die Frequenz zu und nimmt die Amplitude ab.

Betrachtet man die reine Biegebewegung, so kann beispielsweise der dritte Biegemode auf dieselbe Frequenz gelegt werden, wie der oben bestimmte erste Schwingungsmode der Längsschwingung. Dies erlaubt ein maximales Abheben eines freien Endes des jeweiligen Arms 6 vom passiven Elements 1. Es wird also bei maximaler Schrittweite eine grosse Bewegung im Biegemode erreicht, und insgesamt resultiert ein zuverlässiger Vortrieb mit maximal grossen Schritten.

Da die Eigenresonanz in Längsrichtung bei einem uniformen Balken in erster Näherung linear mit der Länge korreliert, die Biegeschwingung hingegen in höheren Potenzen von der Dicke des Resonators abhängt, liegen unabhängige Parameter vor, mit denen das Gesamt-Schwingungsverhalten eines Resonators 3 eingestellt werden kann. Bei gegebenem Material wird durch Wahl der Geometrie das gewünschte Schwingverhalten eingestellt.
In diesem Beispiel hat das als Stange oder Stift ausgebildete passive Element 1 einen Durchmesser von 1.5 Millimetern. Mit dem beschriebenen Motor mit zwei Piezoelementen 4 können Transportkräfte von über 1 N erzeugt werden.

**Figur 33** zeigt einen Verlauf von Antriebskräften respektive Momenten F (beispielsweise in Newton oder Nm) in Abhängigkeit einer Ansteuerfrequenz f (beispielsweise in kHz). Jede Bewegungsart entspricht mindestens einer spezifischen Frequenz f. Mit zunehmender Frequenz treten beispielsweise die folgenden spezifischen Frequenzen auf:
- f31 für ein Losmoment, d.h. es tritt weder eine Klemmwirkung auf, noch wird insgesamt eine Kraft ausgeübt.
- f1 für eine Linearbewegung vorwärts
- f32 für ein Losmoment
- f2 für eine Linearbewegung rückwärts
- f4 für eine Rotation im Uhrzeigersinn
- f5 für eine Rotation im Gegenuhrzeigersinn

Ein zu beachtender Faktor im Betrieb eines Motors gemäss der Erfindung ist die Steifigkeit der Arme. Je steifer ein Arm gebildet wird, desto genauer müssen aktives und passives Element zusammenpassen, und desto grösser ist der Einfluss von Wärmeausdehnungskoeffizienten, Fertigungstoleranzen und Abrieb.

Je weniger steif der Resonator respektive die Arme sind, desto unkritischer sind diese Einflüsse, aber desto grösser muss die Vorspannung sein, um eine optimale Flächenpressung zu gewährleisten.

Eine optimale Flächenpressung ist dann gewährleistet, wenn die punktuelle Kraft gerade so hoch ist, als dass sie keinen Abrieb verursacht. Ist die punktuelle Last zu hoch dann ist die Lebensdauer beschränkt, ist die punktuelle Last zu niedrig, dann ist eigentlich das maximale Potential des Motors nicht ausgeschöpft.

**Figur 2** zeigt einen Antrieb mit jeweils zwei Piezoelementen pro Arm. Die beiden am selben Arm 6 befestigten Piezoelemente 4 sind vorzugsweise durch dieselbe Versorgung angesteuert, aber derart geschaltet, dass sich das eine Piezoelement zusammenzieht, wenn sich das andere ausdehnt. Dadurch wird die Krümmung des Armes unterstützt. In einer anderen Variante dieser Ausführungsform sind die Piezoelemente 4 derart geschaltet, dass sich jeweils gleichzeitig zusammenziehen respektive ausdehnen. In diesem Fall bewirken die Piezoelemente 4 primär eine Verlängerung respektive eine Verkürzung des entsprechenden flachen Abschnitts 9 in der Bewegungsrichtung, und wird die Bewegung der Kontaktbereiche senkrecht zur Ebene der Arme erst durch die asymmetrische Masseverteilung am Ende der Arme hervorgerufen.

**Figur 3** zeigt einen Antrieb mit zwei in die gleiche Richtung zeigenden Armpaaren 5, die um die Bewegungsachse um 90° gegeneinander verdreht sind. Die Arme 6 sind aus einem einzigen, kreuzförmigen Blechstück durch Biegen in dieselbe Richtung geformt. Jeder Arm 6 ist mit einem Anregungsmittel 4 versehen. Die Arme 6 sind mechanisch identisch aufgebaut, und die Anregungsmittel 4 sind elektrisch parallel geschaltet. Im Betrieb schwingt jeder Armpunkt in einer Ebene senkrecht zu der Ebene des jeweiligen flachen Armabschnittes 9. Jeder der Arme verläuft beispielsweise in einem Winkel von mindestens annähernd 45 Grad zum passiven Element 1.

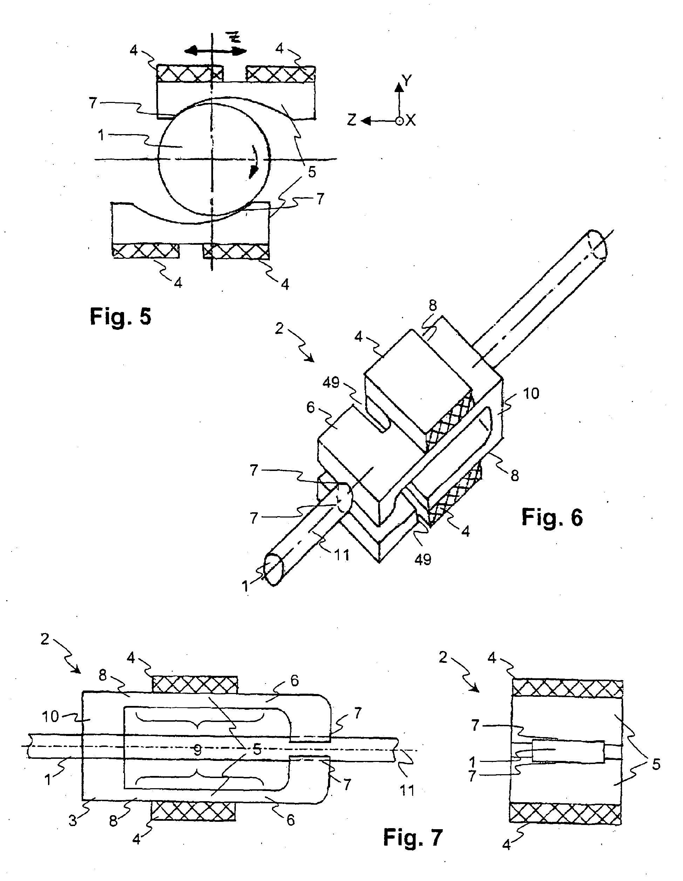

**Figur 4** zeigt einen Antrieb mit je zwei in derselben Ebene nebeneinander angeordneten Piezoelementen 4 je Arm 6, in einer Aufsicht und einer Ansicht in Richtung der Bewegungsachse 11. Durch eine phasenverschobene Ansteuerung der beiden nebeneinanderliegenen Piezoelemente 4 wird eine Bewegungskomponente des Armes 6 innerhalb der XZ-Ebene angeregt. Dies ist in Figur 5 veranschaulicht. Dadurch wird eine Rotation des passiven Elements 1 um die Bewegungsachse angeregt.

Die Piezoelemente 4 auf demselben Arm 6 sind dabei vorzugsweise
- entweder in dieselbe Richtung polarisiert und werden mit Signalen unterschiedlicher Polarität angesteuert,
- oder werden mit demselben Treibersignal angesteuert, sind aber umgekehrt polarisiert auf dem flachen Abschnitt 9 angeordnet.

Die Piezoelemente 4 auf den beiden Armen 6 eines Armpaares 5 sind vorzugsweise derart angeordnet und/oder angesteuert, dass wenn der eine Arm 6 sich in die positive Z-Richtung biegt, der andere Arm 6 sich in die negative Z-Richtung biegt.

**Figur 6** zeigt einen Antrieb mit einer Asymmetrie in der Ebene der Arme, anstelle der asymmetrischen Ansteuerung gemäss den **Figuren 4** und 5. Die Arme sind, beim Blick auf die Armebene, also auf die XZ-Ebene, asymmetrisch geformt. Dies geschieht gemäss der Figur durch einen Einschnitt oder durch Schlitze 49 in dieser Armebene. Alternativ kann dies auch durch eine Ausformung der Arme 6, insbesondere im Bereich der freien Enden, in der Armebene und in Z-Richtung geschehen. Durch solche Asymmetrien wird auch eine Oszillation der Kontaktbereiche 7 innerhalb der Ebene der Arme anregbar. Diese Oszillation überlagert sich mit einer Oszillation senkrecht zur Ebene der Arme, was zu einer Rotation von einzelnen Punkten der Kontaktbereiche 7 in der YZ-Ebene führt, wie sie im Zusammenhang mit der **Figur 32** erklärt ist.

**Figur 7** zeigt einen Antrieb, bei welchem das passive Element 1 flach und im Wesentlichen rechteckig geformt ist. Damit ist nur eine translatorische Bewegung möglich. Analog sind auch beliebige andere prismatische respektive zylinderförmige und nicht rotationssymmetrische Querschnitte des passiven Elements 1 möglich. Die jeweilige Zylinderachse ist dabei parallel zur Bewegungsachse 11 und koinzidiert vorzugsweise mit der Symmetrieachse des Resonators 3.

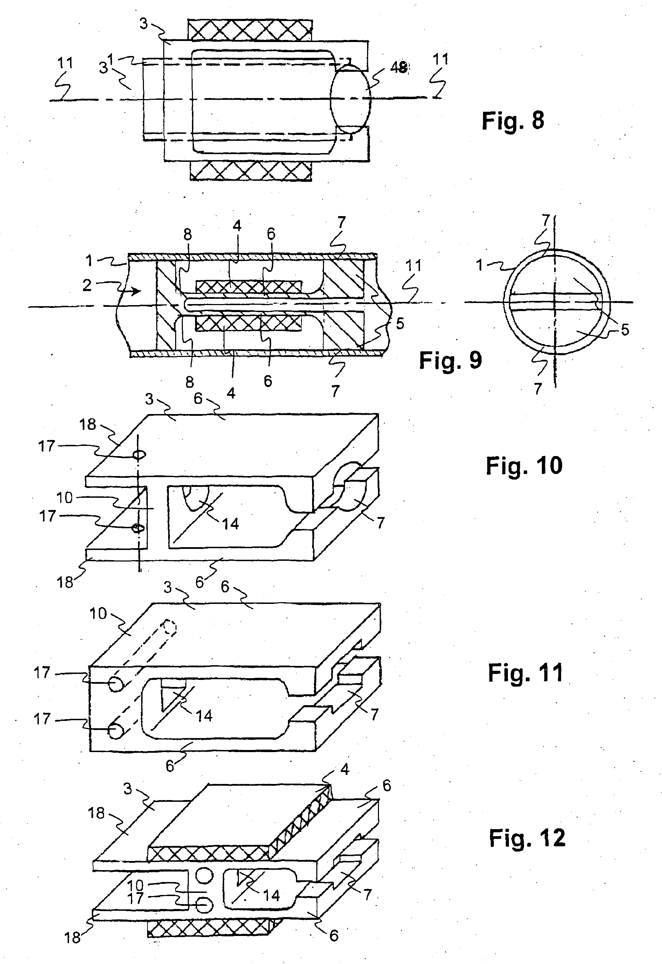

**Figur 8** zeigt einen Antrieb mit einem rohrförmigen passiven Element. Das passive Element 1 ist beispielsweise Träger eines optischen Elementes, wie zum Beispiel einer Kameralinse, 48, so dass der Antrieb für eine Autofokus- oder eine Zoomfunktion verwendbar ist. Das passive Element 1 kann auch einen Lichtleiter wie eine Glasfaser aufweisen und somit positionieren.

**Figur 9** zeigt einen Antrieb, bei welchem das aktive Element als Innenläufer ausgebildet ist, in einer Seitenansicht und einer Ansicht in Richtung der Bewegungsachse. Das Wirkprinzip ist grundsätzlich dasselbe wie bei den bisher gezeigten Beispielen, nur sind der Vorspannkräfte und Antriebskräfte nach aussen gerichtet, und umschliesst das passive Element 1 das aktive Element 2 zumindest teilweise. Auch hier sind rotatorische, translatorische und kombinierte, schraubenförmige Bewegungen möglich. Anstelle eines runden, rohrförmigen passiven Elements 1 kann dieses auch ein anderes Hohlprofil wie ein rechteckiges Profil, oder ein offenes Profil wie beispielsweise ein U-förmiges Profil aufweisen. Dies erlaubt eine saubere Linearbewegung ohne rotatorischen Anteil. Bei einem offenen Profil wie einem U-Profil kann auch das aktive Element 2 festgehalten werden und das passive Element 1 als Läufer dienen.

**Figuren 10** bis **12** zeigen verschiedene Varianten zur Befestigung eines aktiven Elements 2. Das aktive Element 2 soll an einem Bezugskörper, beispielsweise einem mechanischen Gerät, von dem der Antrieb einen Teil bildet, befestigt werden. Oder das aktive Element 2 soll an einem zu bewegenden weiteren Teil befestigt werden. Dazu ist die Befestigung jeweils an Knotenpunkten der räumlichen Schwingungen des Resonators 3 angeordnet. Dadurch werden die Schwingungen wenig beeinflusst und geht wenig Energie über die Befestigung verloren, und treten auch weniger störende akustische Reflexionen über die Befestigung übertragen. Die Knotenpunkte werden beispielsweise mit einer Finite-Elemente (FEM) Analyse des Schwingungsverhaltens des aktiven Elements 2, vorzugsweise bei den verwendeten Antriebsfrequenzen ermittelt.

Gemäss **Figur 10** sind Befestigungslöcher 17 zur Aufnahme von Befestigungselementen, wie beispielsweise von Stiften, in einer Verlängerung 18 der Arme 6 in eine Richtung, die der Armrichtung bezüglich des Verbindungsbereiches 10 gegenüberliegt, und senkrecht zur Ebene der Arme 6 angeordnet. Gemäss Figur 11 sind Befestigungslöcher 17 parallel zur Ebene der Arme 6 im Verbindungsbereich 10 und beiderseits der Öffnung 14 angeordnet. Gemäss **Figur 12** sind die Befestigungslöcher 17 wie in **Figur 11** angeordnet, und sind die Arme über den Verbindungsbereich 10 hinaus in die entgegengesetzte Richtung verlängert. Die Anregungsmittel 4 erstrecken sich von den Armen 6 bis auf die verlängerten Arme 18. Dabei sind die Anregungsmittel 4 beispielsweise bezüglich des Verbindungsbereiches 10 zumindest annähernd zentriert angeordnet. Im Prinzip können, bei Anpassung der Schwingfrequenzen der verlängerten Arme 18, auch Kontaktbereiche 7 an den verlängerten Armen 18 angeordnet sein.

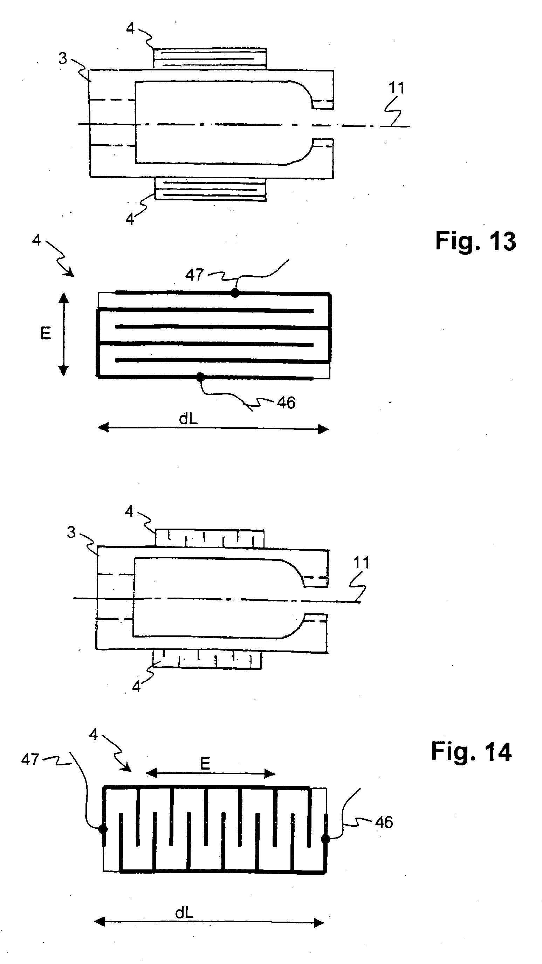

**Figur 13** zeigt einen Piezomotor mit Piezoelementen 4 im d31-Mode in einem Multilayer-Aufbau. Der Aufbau und eine elektrische Kontaktierung eines solchen Piezoelementes 4 sind schematisch im Querschnitt separat dargestellt. Ein Multilayer besteht aus mehreren Lagen von Piezo-Einzelelementen, zwischen welchen jeweils eine leitende Zwischenlage aus z.B. Silber, Nickel, Platin etc. liegt. Die Zwischenlagen sind versetzt und seitlich miteinander verbunden, so, dass z. B. die ungeraden Lagen ein erstes elektrisches Potential aufweisen, und die geraden Lagen ein zweites Potential. Typische Schichtdicken liegen im Bereich von 10 bis 20 Mikron, was dazu führt, dass die elektrische Spannung im Vergleich zum einem Monolayer niedriger sein kann, um dasselbe elektrische Feld zu generieren. Die Richtung des elektrischen Feldes ist mit E bezeichnet, die Richtung der Längenänderung mit dL.

Zum Beispiel benötige ein 0.25 mm dickes Monolayer Piezoelement 100 Volt, um das E-Feld so gross werden zu lassen, dass der Piezoeffekt maximal wird. Ein Multilayer-Piezo mit 20 Schichten, mit einer Schichtdicke von jeweils 12.5 Mikron kann somit mit einer elektrischen Spannung von 5 Volt betrieben werden.

**Figur 14** zeigt einen Piezomotor mit Piezoelementen 4 im d33-Mode, sowie einen Multilayer-Aufbau und eine Kontaktierung solcher Piezoelemente 4. Beim d33-Modus verläuft die Ausdehnungsrichtung dL des Piezoelementes parallel zum angelegten elektrischen Feld E. Entsprechend sind mehrere Piezoelemente aneinandergelegt und verläuft die Polarisierungsrichtung der Piezoelemente parallel zur Ebene entsprechenden flachen Abschnitts 9. Die Piezoelemente weisen elektrische Anschlüsse 46, 47 an den senkrecht zur Hauptebene des flachen Abschnitts 9 respektive des Piezoelements 4 als ganzem, also in der YZ-Ebene verlaufenden Flächen auf.

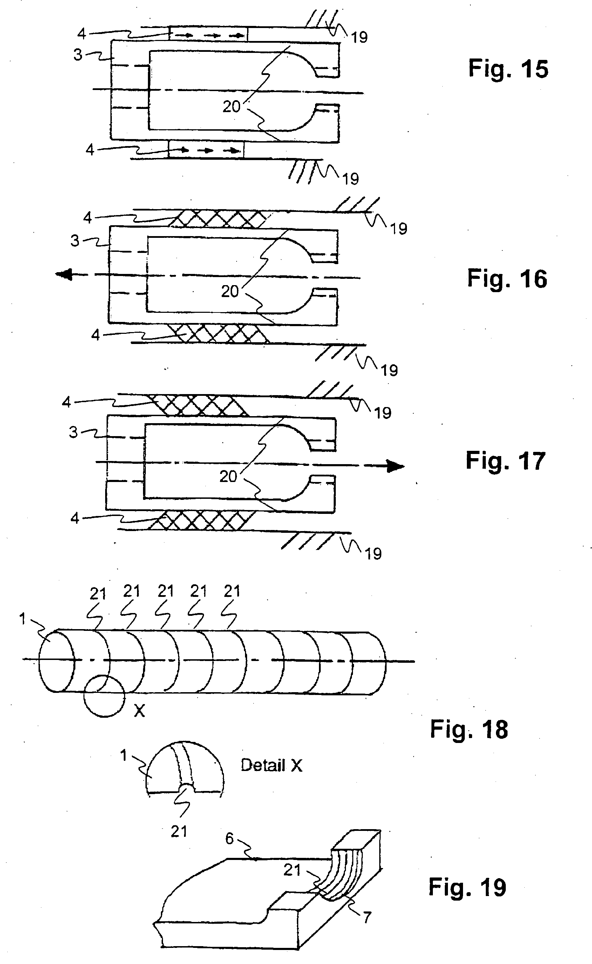

**Figur 15** zeigt einen Piezomotor mit Piezoelementen im d15-Mode. Beim d15-Mode entstehen Scherkräfte im Piezoelement und resultiert eine Scherbewegung. Um diese Scherbewegung zu nutzen, sind die Piezoelemente 4 einerseits wie bisher jeweils an einem Arm 6 befestigt, und mit der dem jeweiligen Arm 6 gegenüberliegenden Aussenfläche an einem gemeinsamen Haltekörper 19 befestigt. **Figuren 16** und **17** zeigen einen Piezomotor gemäss **Figur 15** in verschiedenen Bewegungszuständen: Durch die Scherbewegung der Piezoelemente 4 wird, ohne dass sich dabei die Arme wesentlich verlängern oder verkürzen, der Resonator 3 entlang der Bewegungsachse in X-Richtung hin und her beschleunigt. Dadurch sind, wie weiter oben beschrieben, die freien Enden der Arme 6 in eine antreibende Schwingung versetzbar. Um diese Schwingung zu ermöglichen, weisen die Arme einen freien Bereich 20 zwischen dem Piezoelement 4 und dem Kontaktbereich 7 auf, der nicht mit dem Piezoelement 4 verbunden und dadurch versteift ist.

Gemäss einer Variante dieser Ausführungsform ist der Resonator 3 zweiteilig und weist auch an der linken Seite anstelle des Verbindungsbereiches 10 ein schwingfähiges Ende mit einem freien Bereich und mit eigenen Kontaktbereichen 7 auf. Ähnlich wie in der Figur 13 kann auch ein Steg zwischen den beiden Teilen des Resonators 3 angeordnet sein, so dass dieser wieder einstückig ist.

**Figur 18** zeigt eine weitere Ausgestaltung eines passiven Elements 1. Es sind am Umfang des passiven Elements 1 Rillen 21 eingeformt. Diese ermöglichen, dass Schmutz und/oder Abriebpartikel von der Umfangsfläche abgeführt werden. Dadurch werden Schwankungen der Antriebskraft und der Geschwindigkeit verringert. Die Rillen 21 verlaufen vorzugsweise kreisförmig oder schraubenförmig am Umfang.

**Figuren 19** zeigt analog dazu Rillen 21, die am Kontaktbereich 7 eines aktiven Elements 2 geformt sind. Die Rillen 21 bilden in einer anderen Ausführungsform eine Mikroverzahnung und verbessern dadurch die Kraftübertragung zwischen dem aktiven Element 2 und den passiven Element 1.

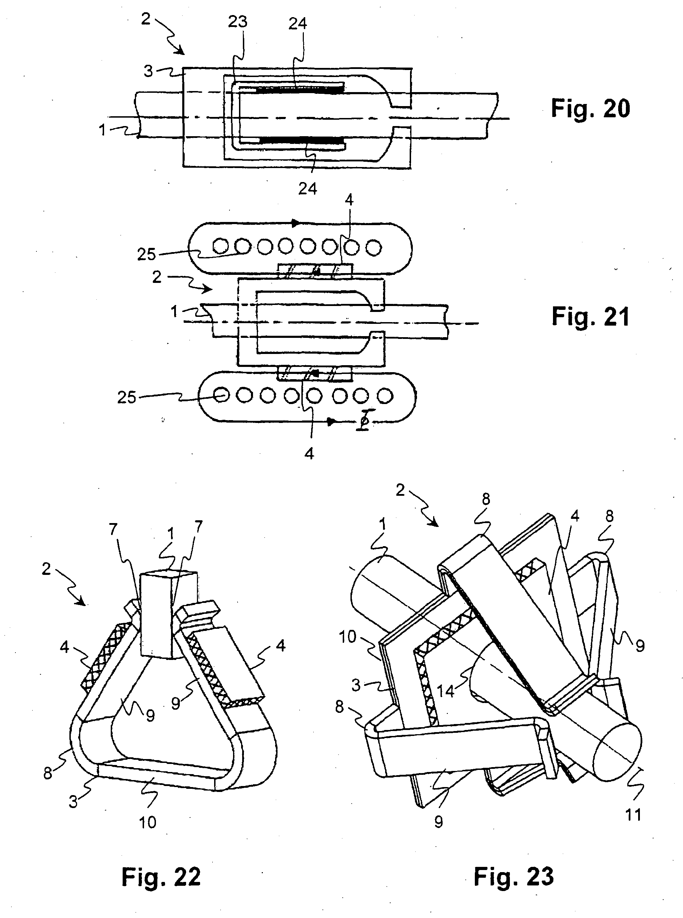

**Figur 20** zeigt einen U-förmigen oder stimmgabelförmigen Abstreifer 23, der innerhalb eines Armpaares 5 angeordnet ist, und am Verbindungsbereich 10 befestigt ist, so dass der Abstreifer 23 keinen merkbaren Einfluss auf die Schwingungen des Resonators 3 hat. Der Abstreifer 23 weist Reinigungsmittel 24 wie beispielsweise Filz- oder Gummistreifen auf, welche sich mit dem aktiven Element 2 mit bewegen und dabei das passive Element 1 reinigen.

**Figur 21** zeigt einen Antrieb mit einem magnetostriktiven Wirkprinzip. Im Allgemeinen kann entweder das passive Element 1 oder das aktive Element 2 bezüglich einer Umgebung festgehalten werden. Wird das passive Element 1 festgehalten, so wird das aktive Element 2 als Läufer bezeichnet bei längeren translatorischen oder andauernden rotatorischen Bewegungen wird die Energieversorgung des aktiven Elements 2 zum Problem. Dieses Problem wird in der Ausführungsform nach **Figur 21** gelöst, indem eine mit dem passiven Element 1 mechanisch verbundene Vorrichtung zum Erzeugen eines Magnetfeldes entlang des passiven Elements 1 angeordnet ist. Diese Vorrichtung ist beispielsweise eine Spule 25, deren Windungen um das passive Element 1 und einen Raum für das aktive Element 2 herum verlaufen. In der Spule 25 wird ein Magnetfeld erzeugt. Das aktive Element 2 weist als Anregungsmittel 4 ein magnetostriktives Element, beispielsweise aus Terfenol auf, welches sich in Abhängigkeit des mit Φ bezeichneten magnetischen Flusses mechanisch deformiert. Dadurch sind Schwingungen des Resonators 3 anregbar.

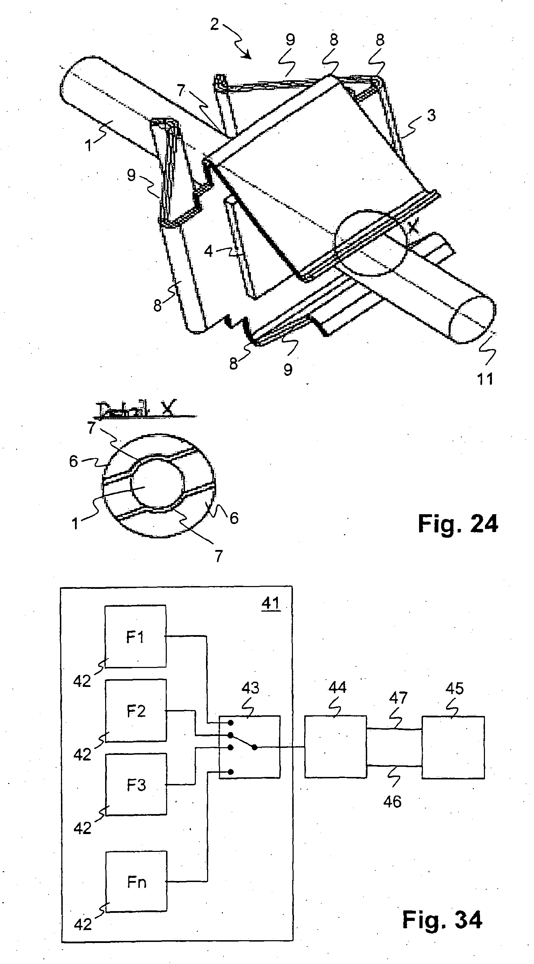

**Figur 22** zeigt einen Antrieb mit einem einstückigen, gebogenen Resonator 3, ähnlich jenem aus **Figur 3****,** jedoch mit nur zwei Armen 6. Der Resonator 3 ist aus einem einzigen flachen, länglichen Blechstück an zwei Federbereichen 8 gebogen. Der Bereich zwischen den Federbereichen 8 ist der Verbindungsbereich 10, an welchem der Resonator 3 an einem anderen Körper befestigt ist. Die beiden Bereiche zwischen den Federbereichen 8 und den Enden des Bleches bilden die Arme 6 mit den flachen Abschnitten 9. Die Arme 6 verlaufen beispielsweise im Winkel von ca. 45 Grad bezüglich des Verbindungsbereiches 10 und sind mit den Anregungsmitteln 4 respektive Piezoelementen 4 bestückt. An den freien Enden der Arme 6 ist das Blech leicht aufgebogen, wodurch sich einerseits die Kontaktbereiche 7 und andererseits die weiter oben erwähnte Asymmetrie senkrecht zur Armebene ergeben. Die Kontaktbereiche 7 sind vorzugsweise an die Umfangsform des passiven Elements 1 angepasst wie in der Figur 24 gezeigt ist. Die gezeigte Ausführungsform ist für eine begrenzte Linearbewegung des passiven Elements 1 ausgelegt. Für grössere Bewegungen kann im Verbindungsbereich 10 eine Öffnung 14 vorgesehen sein.

**Figur 23** zeigt einen Antrieb mit nur einem Anregungsmittel 4. Der Antrieb ist ähnlich zu jenem der **Figur 3** geformt, weist aber nur ein Piezoelement 4 auf, welches am Verbindungsbereich 10 angeordnet ist, sowie breitere Arme. Die vier Arme 6 weisen dieselbe Orientierung bezüglich der Bewegungsachse auf und sind vorzugsweise mechanisch gleich gestaltet. Da keine aktiven Elemente an den schwingenden Armen angebracht sind, können deren Eigenfrequenzen sehr genau eingestellt werden. Bei aktiven Armen wie in den **Figuren 3** und **22** wird, bei elektrischer Parallelansteuerung der Anregungsmittel 4, jedem der Arme 6 dieselbe Frequenz aufgezwungen. Passive Arme wie in den Figuren 23 und 24 schwingen hingegen frei. Daher tritt bei passiven Armen in der Regel ein geringerer Energiebedarf auf. In der Realität weisen die passiven Arme 6 jeweils eigene, leicht voneinander abweichende Resonanzfrequenzen auf. Diese Abweichungen sind entweder in einer tolerierbaren Grösse, oder sind durch Trimmen reduzierbar. Das Trimmen geschieht zum Beispiel durch Erosion von Material des Arms, beispielsweise mit einem Laser.

**Figur 24** zeigt einen Antrieb, ähnlich zu jenem der **Figur 23****,** aber mit zwei Armpaaren, die in entgegengesetzte Richtungen zeigen und um 90 Grad um die Bewegungsachse 11 gegeneinander verdreht sind. Die Eigenfrequenzen und Schwingungsmodi der Arme 7 sind derart aufeinander abgestimmt, dass bei einer ersten Frequenz, beispielsweise 200 kHz, das obere Armpaar 5 eine ziehende und das untere Armpaar 5 eine stossende Bewegung ausführt, und sich dadurch das aktive Element 2 nach oben bewegt. Bei einer zweiten Frequenz, beispielsweise 300 kHz führt das untere Armpaar 5 eine ziehende und das obere Armpaar 5 eine stossende Bewegung aus, und das aktive Element 2 bewegt sich nach unten.

Der Antrieb ist vorzugsweise aus einem einzigen, kreuzförmigen Blechstück geformt, aus welchem ein erstes Armpaar 5 durch Biegen zweier Arme des Kreuzes in eine erste Richtung aus der Blechebene und ein zweites Armpaar 5 durch Biegen der anderen Arme in die entgegengesetzte Richtung entsteht.

In einer Detailansicht zur **Figur 24** ist beispielhaft eine runde Ausformung der Kontaktbereiche 7 gezeigt. Diese Ausformung bildet einen Teil einer Zylinderinnenfläche und korrespondiert somit mit der Form des zylindrischen passiven Elements 1. Entsprechende Ausformungen können auch an den Ausführungsformen gemäss den anderen Figuren ausgestaltet sein.

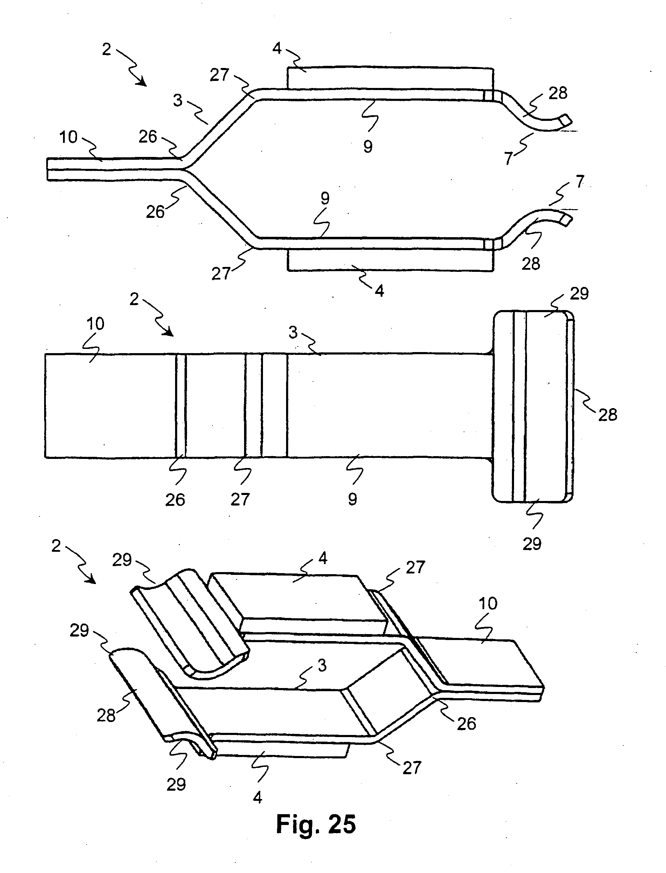

**Figuren 25** bis **27** zeigen aktive Elemente aus gebogenen Blechteilen, jeweils in verschiedenen Ansichten. Die Resonator 3 sind jeweils als Stanz- und Biegeteile kosfengünstig herstellbar.

**Figur 25** zeigt, in verschiedenen Ansichten, einen Antrieb, dessen Resonator 3 aus zwei länglichen Blechen besteht, die im Verbindungsbereich 10 fest miteinander verbunden, beispielsweise verschweisst sind. Im Verbindungsbereich 10 verlaufen die beiden Bleche parallel zueinander und parallel zu einer Symmetrieebene des Resonators 3. Daran anschliessend sind die Bleche durch jeweils einen ersten Knick 26 voneinander weggebogen und anschliessend durch einen zweiten Knick 27 wieder aufeinander zu gebogen. Sowohl der erste als der zweite Knick und der dazwischen liegende Blechabschnitt wirken als Federbereich 8. Anschliessend an den zweiten Knick 27 liegen die flachen Abschnitte 9 mit daran befestigten Anregungsmitteln 4 im Wesentlichen parallel zueinander. Anschliessend an die flachen Abschnitte 9 sind die Bleche asymmetrisch bezüglich der Ebene des jeweiligen flachen Abschnitts 9 aus dieser Ebene heraus aufeinander zu gebogen und bilden zwei gegeneinander gewölbte Kontaktabschnitte 28 mit den Kontaktbereichen 7. Im Bereich dieser Kontaktabschnitte 28 sind die Bleche vorzugsweise breiter als in den flachen Abschnitten 9. Dadurch weisen die Kontaktabschnitte 28 eine relativ grosse Masse, ausserhalb der Ebene der flachen Abschnitte 9 auf, was die charakteristischen Schwingungen im Sinne der Erfindung verbessert. Durch Abschleifen der seitlich hervorstehenden Teile 29 der Kontaktabschnitte 28 können die Schwingfrequenzen der Arme 6 abgestimmt werden.

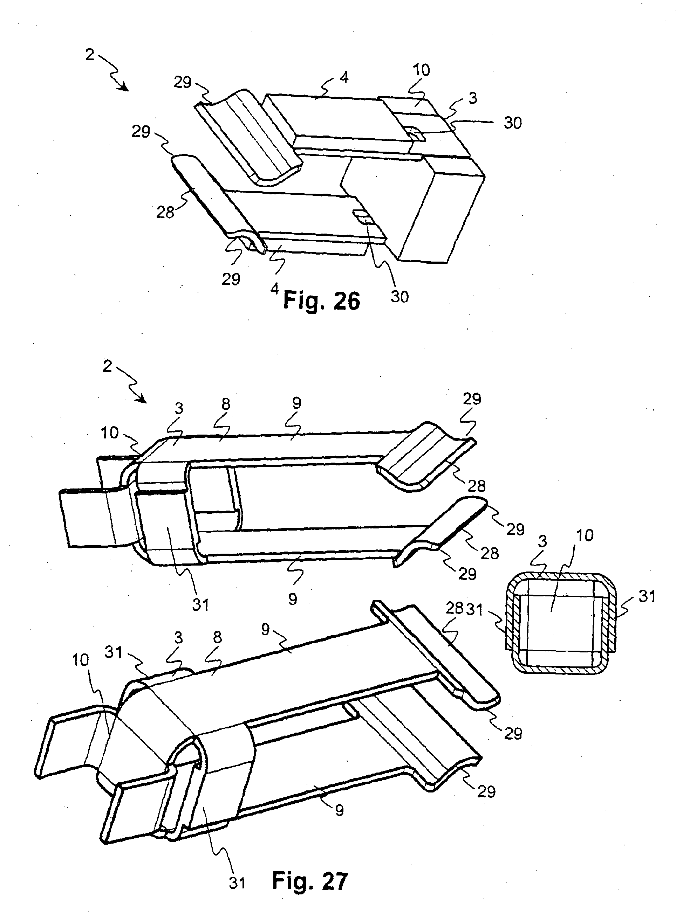

Die Arme sind beispielsweise ca. 4 mm lang und aus CuBe-Blech gestanzt, wobei die Betriebsfrequenzen beispielsweise bei 50 kHz bis 300 kHz liegen. Die Piezoelemente 4 sind einerseits über die Arme 6 und andererseits über (nicht gezeichnete) Drähte kontaktiert. Dies ist auch für die folgenden beiden Ausführungsformen gemäss den **Figuren 26** und **27** der Fall.

In einer Ausführungsform sind die seitlich hervorstehenden Teile 29 der Kontaktabschnitte unterschiedlich lang. Damit liegt also eine Asymmetrie der Arme 6 in der Aufsicht auf die Ebene der flachen Abschnitte 9 vor, wodurch eine Schwingung zur Anregung einer rotatorischen Bewegung erzeugbar ist, wie im Zusammenhang mit **Figuren 5** und 6 erklärt ist.

**Figur 26** zeigt einen Antrieb, bei dem die Arme 6 im freien Bereich ähnlich wie in der vorangehenden Ausführungsform ausgestaltet sind. Als Verbindungsbereich 10 ist jedoch ein weiterer Körper vorgesehen, an dem die Arme 6 jeweils einzeln befestigt sind. Zur Verminderung der Steifigkeit zwischen den Armen 6 und dem Verbindungsbereich 10 sind die Arme 6 in der Nähe des Verbindungsbereiches 10 mit einer geringeren Querschnittsfläche geformt, wodurch ein Federbereich 8 gebildet wird. Beispielsweise sind an den Armen Ausnehmungen 30 vorgesehen, oder die Arme sind dünner oder schmaler geformt.

**Figur 27** zeigt, in zwei verschiedenen Ansichten und in einem Querschnitt, einen weiteren Resonator 3 mit einem wiederum ähnlichen Endbereich. Der Resonator 3 ist jedoch aus einem einzigen Blech gestanzt und gebogen. Aus einer Ebene des Verbindungsbereiches 10 heraus sind zwei Arme aufeinander zu gebogen und verlaufen bis zu den Kontaktabschnitten 28 parallel zueinander. Diese parallelen Abschnitte 9 sind zur Befestigung der Anregungsmittel 4 (nicht eingezeichnet) vorgesehen. Anschliessend an den Verbindungsbereich 10 weisen die Arme 6 Versteifungslaschen 31 auf, die jeweils zum gegenüberliegenden Arm 6 hin gebogen und mit einer gegenüberliegenden Versteifungslasche 31 fest verbunden sind. Durch die derart gefalteten und miteinander verbundenen Blechlaschen 31 ist der Resonator 3 am festen Ende versteift.

Aus der Ebene des Verbindungsbereiches 10 heraus sind vorzugsweise zwei Befestigungslaschen in eine den Armen 6 entgegengesetzte Richtung gebogen.

**Figur 28** zeigt einen nicht erfindungsgemäßen Antrieb mit einem senkrecht zur Symmetrieachse eines Armpaares angeordneten Zylinders als passivem Element.

**Figur 29** zeigt einen nicht erfindungsgemäßen Antrieb, bei welchem das passive Element zwei gegenläufig drehbare Zylinder als Rotoren 15 aufweist.

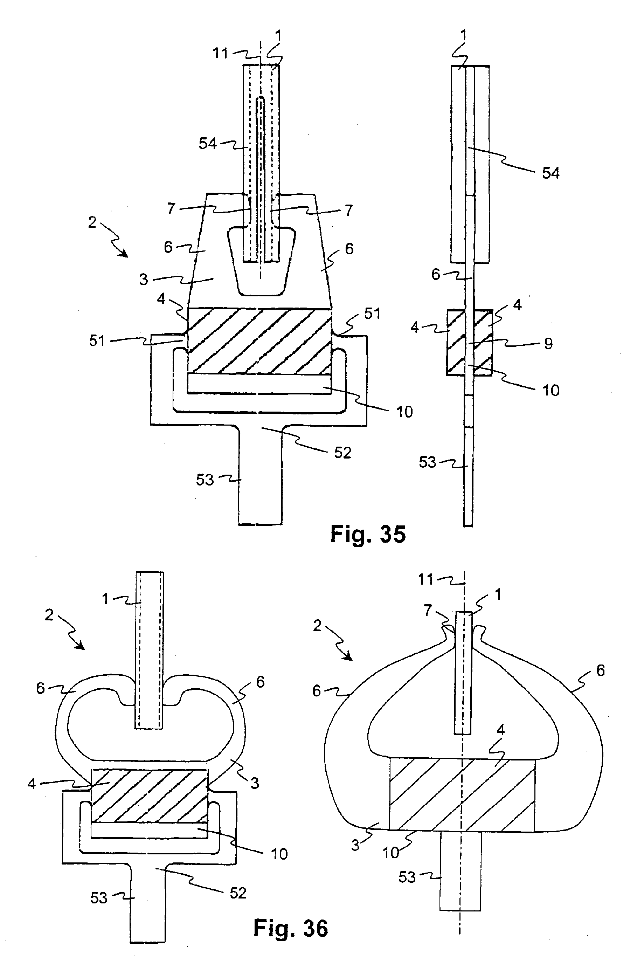

**Figur 35** zeigt eine erste bevorzugte Ausfühnmgsform der Erfinduug, welche eine besonders flache Gestaltung aufweist, in einer Aufsicht und einer Seitenansicht. Das aktive Element 2 weist flache Arme 6 auf, deren Ebenen parallel zueinander und in derselben Ebene liegen. Parallel zu dieser Ebene oder in dieser Ebene selber ist der flache Abschnitt 9 des Resonators 3 mit dem Anregungsmittel 4 angeordnet. Die antreibenden Bewegungen der Kontaktbereiche 7 finden ebenfalls parallel zu dieser Ebene statt. Der Resonator 3 geht über Übergangsbereiche 51 in zwei federnde Arme einer Y-förmigen Halterung 53 über. Dort, wo die Arme der Halterung 53 sich vereinigen, liegt ein Knotenpunkt 52 von Schwingungen des Resonators 3. Der Resonator 3 und die Halterung 53 sind vorzugsweise aus einem einzigen flachen blechteil geformt.

Das passive Element 1 ist länglich und ist entlang seiner Hauptausdehnungsrichtung oder Bewegungsachse 11 bezüglich des aktiven Elements 2 beweglich angeordnet. Zur Rührung weist das passive Element 1 optional einander gegenüberliegende Längsnuten 54 zur Aufnahme der Kontaktbereiche 7 des aktiven Elements 2 auf.

Das passive Element 1 ist erfindungsgemäß in sich federnd konstruiert, so dass die Bereiche, welche mit den Kontaktbereichen 7 des aktiven Elements 2 in Berührung kommen, gegeneinander federnd bewegbar sind. Dadurch können die Arme 6 eine relativ grosse Steifigkeit in der Armebene aufweisen. Die Feder dient unter anderem zur Kompensation von Abnützungen der Kontaktbereiche 7 und des passiven Elements 1.

Die Arme 6 eines Armpaares 5 wirken einander bezüglich des passiven Elementes 2 in Richtungen, die von der zulässigen Bewegungsrichtung des passiven Elementes 2 abweichen, entgegen, und wirken in der Bewegungsrichtung miteinander, verstärken also ihre Wirkung in der Bewegungsrichtung. Die Kontaktbereiche 7 können sich nach Massgabe der Anregungsfrequenz auch ausserhalb der Ebene der flachen Arme 6 respektive des Resonators 3 bewegen, also eine in drei Dimensionen verlaufende Schwingung ausführen. Um solche Schwingungsmodi für einen Antrieb zu nutzen ist das passive Element 1 vorzugsweise ohne die in **Figur 35** gezeigte Nut ausgeführt, beispielsweise mit flachen Platten, die gegeneinander gefedert sind. Die Ebene der Platten, und auch ihre Bewegungsrichtung verläuft vorzugsweise senkrecht zu einer Verbindungsgeraden zwischen den Kontaktbereichen 7 im Ruhezustand. Vorzugsweise verläuft die Bewegungsrichtung auch parallel zur Ebene der Armbleche, sie kann aber auch senkrecht oder im Winkel zu dieser Ebene verlaufen. Es existieren meist mehrere Schwingungsmodi, die eine Bewegung vorwärts oder rückwärts parallel zur Ebene der Arme ergeben. Für den Betrieb wird ein Paar von entsprechenden Anregungsfrequenzen - eine für vorwärts, eine für rückwärts - gewählt, die nahe beieinander liegen. Dies hat den Vorteil, dass dieselbe Spule für beide Frequenzen zur Spannungserhöhung verwendet werden kann.

Wie in **Figur 36** gezeigt, können die Arme 6 federnd geformt und dafür das passive Element 1 ohne Federung ausgebildet sein. Auch in diesen nicht erfindungsgemäßen Ausführungsformen sind die Arme 6, der flache Abschnitt 9 mit dem Piezoelement 4 sowie die Halterung 53 vorzugsweise an einem einzigen Teil ausgebildet Die Halterung kann auch ohne die Y-förmigen Arme direkt an der Seite des flachen Abschnitts 9 anschliessen, welche den Armen 6 gegenüberliegt.

Zur Anregung der Schwingungen in den Ausführungsformen gemäss den **Figuren 35** und **36** sind die Anregungsmittel 4 mit ihrer Ausdehnungsrichtung parallel zur Ebene des Resonators 3 angeordnet. Es kann auch nur ein einzelnes Piezoelement 4 auf einer Seite des Resonators 3 vorliegen. Bei genügend hohen Anregungsfrequenzen werden dabei vor allem die Schwingungen in der Resonator- respektive Armebene angeregt, und tieferfrequente Biegeschwingungen des Resonators 3 werden nicht signifikant angeregt.

**Figur 34** zeigt ein Blockschema einer Schaltung zur Ansteuerung eines Piezomotors. Die Treiberschaltung weist einen Signalgenerator oder Mehrfrequenz-Generator 41 zur Erzeugung von Signalen unterschiedlicher Frequenzen auf. Der Mehrfrequenz-Generator 41 weist dazu beispielsweise mehrere einzelne Frequenzgeneratoren 42 auf, von deren Ausgangssignalen eines durch einen Umschalter 43 ausgewählt werden kann. Dieses Signal wird als Ausgangssignal des Mehrn-equenz-Generators 41 auf einen Verstärker 44 geführt. Mit dem Ausgangssignal des Verstärkers wird der Motor 45 angesteuert. Zur Anregung von kombinierten, z.B. schraubenförmigen Bewegungen können die einzelnen Frequenzgeneratoren 42 auch Signale mit mehreren überlagerten Frequenzkomponenten erzeugen. Der Signalgenerator 41 kann konventionell (analog) oder numerisch (digital) aufgebaut sein. Je nach Anwendung, Integration und Komplexität des Ansteuersignals wird die geeignete Ansteuerung gewählt. Dabei können Frequenz, Signalform und Amplitude variiert werden. Die Amplitude bestimmt im Wesentlichen die Verfahrgeschwindigkeit.

Der Verstärker 44 oder Treiber passt das erzeugte Signal vom Generator 41 an den Piezomotor 45 an. Je nach Form und Grösse des Ansteuersignals wird eine benötigte Treibertopologie gewählt. Für Rechteckansteuerung reicht eine Brückenschaltung. Für alle anderen Signalformen wird ein linearer Verstärker oder ein digitaler Verstärker benötigt, z.B. ein "Class D" Verstärker für Pulsbreitenmodulation (PWM). Bei Verwendung von Mulitlayer-Piezolementen kann unter Umständen ganz auf den Verstärker 44 verzichtet werden.

Je nach Ansteuermodus wird zwischen Piezomotor 45 und Treiberelektronik 44 eine Induktivität geschaltet. Im Idealfall wird die Induktivität so ausgelegt, dass sie mit der Piezomotorkapazität einen Serien-Resonanzschwingkreis in einer bevorzugten Motorbetriebsfrequenz bildet. Dadurch kann eine Erhöhung der Spannung über den Piezoelementen 4 erzielt werden. Bei einer Rechteckansteuerung dient der Serienresonanzkreis zudem als Filter und Signalumformer: Der von einem Rechtecksignal gespeiste Piezomotor wird durch das Zwischenschalten einer Induktivität mit einem in der Amplitude erhöhten Sinussigaal angesteuert.

Der Schwingkreis, bestehend aus Piezomodul und Spule, erlaubt - in Abhängigkeit seiner Güte - rund eine Vervierfachung der Spannung. Durch Umpolen der Spannungsversorgung kann die wirksame Spannung verdoppelt werden. Somit kann insgesamt mit beispielsweise einer Versorgungsspannung von 2.5 V eine Spannung von 20 V am Piezomodul erzeugt werden.

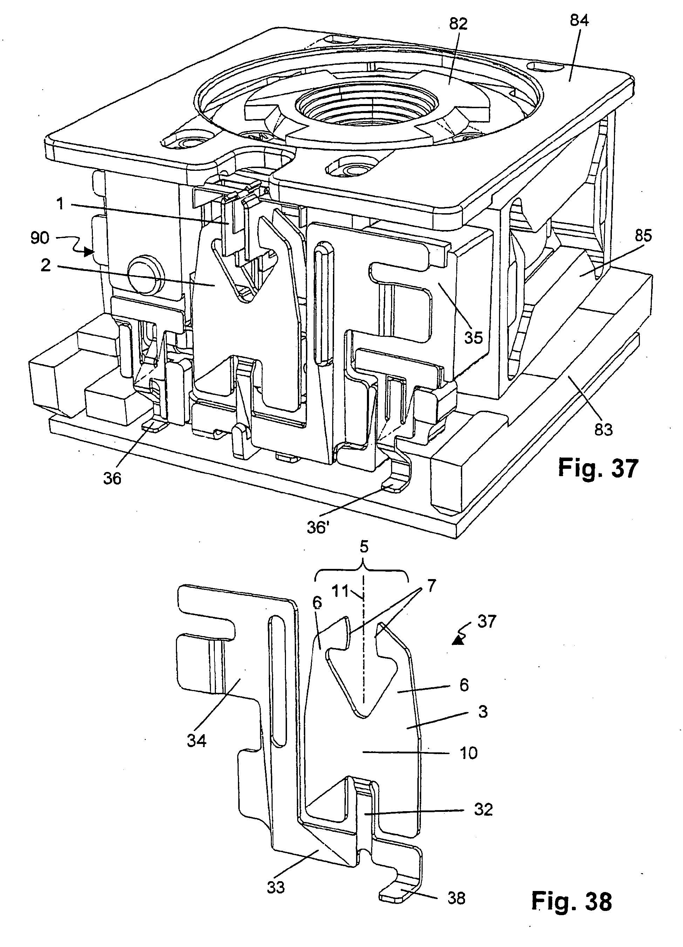

Die Frequenzen für die verschiedenen Bewegungsrichtungen werden vorzugsweise nahe zueinander ausgewählt, so dass die Spule für beide Frequenzen möglichst wirksam ist. Die maximale Spannung des Schwingkreises wird dabei mindestens annähernd in die Mitte zwischen die beiden Frequenzen gelegt. Typische Frequenzen für einen Resonator 3 gemäss den **Figuren 37** bis **44** mit beispielsweise Ausdehnungen von 3 bis 6 mm liegen im Bereich zwischen 400 und 600 kHz.

**Figur 37** zeigt eine erfindungsgemäße Positionierungseinheit zur Positionierung einer Linse. Auf einem Grundkörper 83 ist ein aktives Teilmodul 90 des Antriebs montiert, welches einen angetriebenen Körper 82 über ein passive Element 1 des Antriebs antreibt. Der angetriebene Körper 82 ist über eine Parallelmechanik 85 am Grundkörper 83 montiert. Über dem angetriebenen Körper 82 ist ein Deckelteil 84 als Teil des Grundkörpers 83 montiert. Der angetriebenene Körper 82 weist eine Halterung mit einer Linse auf, währenddem der Grundkörper 83 einen Bilderfassungschip trägt, auf den die Linse durch Bewegung des angetriebenen Körpers 82 fokussierbar ist. Die Parallelmechanik 85 erlaubt eine im wesentlichen lineare respektive gerade Bewegung des angetriebenen Körpers 82 mit dem passiven Element 1 bezüglich dem Grundkörper 83 respektive dem aktiven Teilmodul 90. Streng genommen ist diese Bewegung eine Parallelverschiebung entlang eines Kreisbogens, für praktische Zwecke im Zusammenhang mit dem Antrieb kann sie aber auch als gerade betrachtet werden.

Das aktive Teilmodul 90 weist zwei zueinander parallel angeordnete Resonatoren 3,3' auf, die jeder für sich im Wesentlichen gemäss dem Prinzip der Figur 35 wirkt. Die Kontaktbereiche 7 der Resonatoren 3,3' greifen an Kontaktplatten 72 des passiven Elements 1 an, die gegeneinander federnd angeordnet sind und durch diese Federwirkung gegen die Kontaktbereiche 7 gedrückt werden. Bei Anregung eines gemeinsamen Anregungsmittels 4 werden die vier Kontaktbereiche 7 der beiden Resonatoren 3,3' in räumliche Schwingungen versetzt, welche die Kontaktplatten 72 und damit den angetriebenen Körper 82 - je nach Anregungsfrequenz -in die eine oder andere Richtung treiben. Die Schwingungen weisen in der Regel Komponenten in drei Dimensionen auf, wie im Zusammenhang mit der Ausführungsform der **Figur 35** erklärt ist. Davon wird vorzugsweise eine Vor- und Rückwärtsbewegung parallel zu den Ebenen der Resonatoren 3,3' genutzt und werden entsprechende Frequenzen zur Anregung ausgewählt

Der Aufbau des aktiven Teilmoduls 90 wird anhand der folgenden **Figuren 38** bis **40** erklärt: **Figur 38** zeigt einen ersten Resonator 3 mit einstückig angeformter Aufhängung 32. Die Aufhängung 32 führt vom Resonator 3 zu einem Basiselement 33 und einer Kontaktierungslasche 34 zur elektrischen Kontaktierung. Die genannten Komponenten sind einstückig aus einem dünnen Teil mit im Wesentlichen konstanter Dicke gefertigt, beispielsweise aus Blech gestanzt. Im Folgenden wird dieses Teil Resonatorblech 37 genannt. Ein zweites Resonatorblech 37 mit einem zweiten Resonator 3' ist vorzugsweise identisch geformt und spiegelsymmetrisch zum ersten Resonator 3 angeordnet, wie in der **Figur 37** sichtbar ist. Durch die identisch Gestaltung werden die Herstellungskosten verringert, und können die mechanische Eigenschaften der beiden Resonatoren 3,3' nahe beieinander gehalten werden. Jeweils eine Verbindungslasche 38 fuhrt den Basiselementen 33,33' zum gegenüberliegenden Resonator 3,3' und dient zur elektrischen Verbindung der Resonatoren 3,3'.

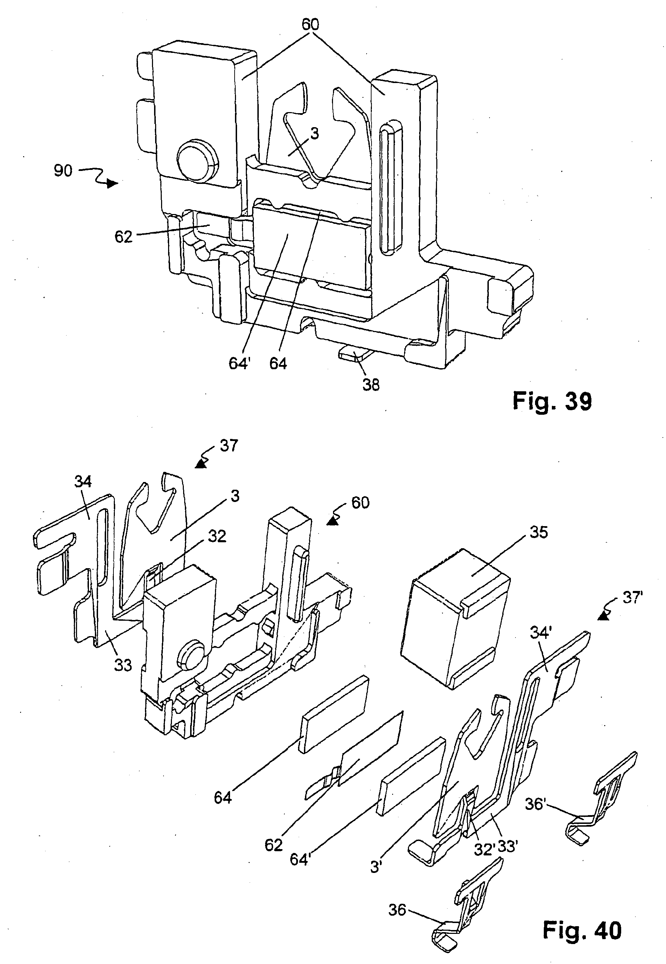

**Figur 39** zeigt ein teilweise montiertes aktives Teilmodul, 90 der Positionierungseinheit: Auf dem Resonator 3 ist ein Trägerelement 60 angebracht, und in einer Öffnung des Trägerelementes 60 sind, parallel zur Ebene eines flachen Abschnitts des Resonators 3 eine erste Piezoplatte 64, darauf eine Zwischenelektrode 62 und darauf wiederum eine zweite Piezoplatte 64' angeordnet Die Piezoplatten 64, 64' und die Zwischenelektrode 62 sind durch Distanzierungsnasen an der Öffnung in derselben zentriert, wobei die Piezoplatten 64, 64' immer noch schwingfähig bleiben. Das Trägerelement 60 ist vorzugsweise aus Kunststoff und im Spritzgussverfahren hergestellt.

**Figur 40** zeigt eine Explosionszeichnung des aktiven Teilmoduls. Nebst den bereits erwähnten Komponenten sind hier auch noch das zweite Resonatorblech 37' dargestellt, sowie eine Spule 35 und zwei Anschlusslaschen 36, 36'. Eine erste Anschlusslasche 36 ist zur elektrischen Kontaktierung der Zwischenelektrode 62 angeordnet, eine zweite Anschlusslasche 36' ist zur elektrischen Kontaktierung eines ersten Anschlusses der Spule 35 angeordnet. Ein zweiter Anschluss der Spule 35 kontaktiert die Kontaktierungslasche 34' des zweiten Resonatorbleches 37'.

Das aktive Teilmodul 90 weist also einen Schwingkreis, gebildet aus der Spule 35 und einem Doppelpiezo zwischen den Resonatoren 3,3' auf. Der Aufbau des Anregungsmittels 4 als zweischichtiges Piezoelement aus zwei parallelen Platten um die Zwischenelektrode 62 erlaubt, dass die Resonatoren 3,3', welche die äusseren Elektroden des Piezoelementes bilden, auf dem gleichen elektrischen Potential sind Dies bedeutet wiederum, dass das passive Element 1, welches die Kontaktbereiche 7 von beiden Resonatoren 3,3' berührt, elektrisch leitend sein darf.

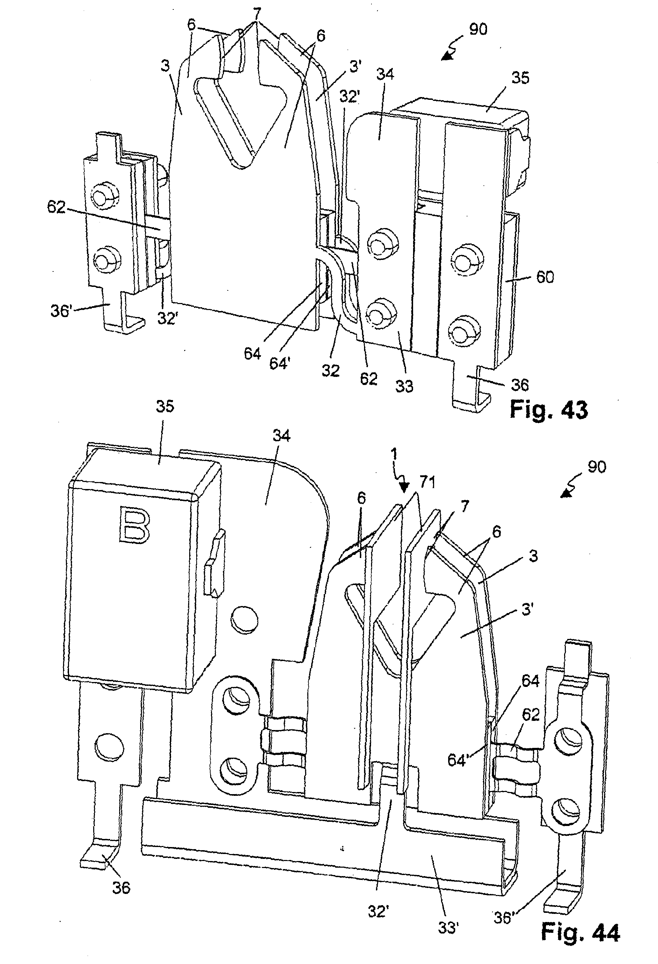

Da die Aufhängung 32 der Resonatoren 3,3' zugleich eine elektrische Verbindung ist, sind keine Drähte und ist kein Bonding zur Kontaktierung des Anregungsmittels 4 erforderlich. Die Aufhängung 32 führt aus der Ebene des Resonators 3 heraus und von diesem weg, wobei dies vorzugsweise in einem Bereich des Resonators 3 geschieht, der einem bevorzugten Schwingungsknoten des Antriebs entspricht, In der vorliegenden Ausführungsform der Erfindung liegt dieser Bereich zumindest annähernd bei der Mitte der Piezoplatte 64. In einer anderen Ausführungsformn der Erfindung, beispielsweise gemäss **Figur 43** liegt dieser Bereich an der Mitte einer Seite einer rechteckigen Piezoplatte 64. In beiden Ausführungsformen werden so die Schwingungen der Resonatoren 3,3' und der Piezoplatten 64, 64' von den übrigen Teilen des aktiven Teilmoduls 90 entkoppelt. Zum gleichen Zweck ist die Zwischenelektrode 62 in einem Übergangsbereich gewellt und federnd ausgeführt. Der Übergangsbereich führt von den Piezoplatten 64, 64' zum Trägerelement 60, wo die Zwischenelektrode 62 durch die erste Anschlusslasche 36 kontaktiert wird.

Das Elastizitätsmodul der Resonatoren 3,3' und der Piezoplatte 64, 64' ist um ein Vielfaches höher als jenes des Klebstoffes und des Trägerelementes 60. Somit werden die Modi und Schwingungsfrequenzen durch letztere nicht wesentlich beeinffusst, sondern allenfalls gedämpft.

Zur Herstellung des aktiven Teilmoduls 90 werden vorzugsweise die folgenden Teile in der angegebenen Reihenfolge aufeinander montiert:
- ein erster Resonator 3;
- ein Trägerelement 60;
- eine erste Piezoplatte 64;
- optional eine Zwischenelektrode 62 und eine zweite Piezoplatte 64';und
- ein zweiter Resonator 3'.

Dabei wird jeweils zwischen zwei Schritten zumindest stellenweise ein elektrisch leitender Klebstoff zwischen die aufeinandergelegten Teile gebracht. Der Klebstoff ist beispielsweise ein durch Erwärmung aushärtbarer Kleber mit mikroskopischen Nickelkugeln genormter Grösste. Die Leitfähigkeit des Klebers entsteht nur, wenn zwei Leiter gegeneinander gedrückt werden, so dass die Nickelkugeln den Abstand zwischen den Leitern überbrücken. In andere Richtungen bleibt der Klebstoff nichtleitend. Deshalb kann der Klebstoff grosszügig aufgetragen werden, und beispielsweise auch um die Piezoplatten 64, 64' herum und in den Zwischenraum zwischen den Piezoplatten 64, 64' und dem Trägerelement 60 gelangen, ohne dass ein Kurzschluss entsteht.

Die genannten Teile werden also, jeweils mit Klebstoff dazwischen, aufeinandergestapelt, und dann, währenddem sie zusammengedrückt werden, erwärmt. Beim Aushärten schwindet der Klebstoff und zieht die Leiter zusammen, so dass ein dauernder Druck auf die Nickelkugeln und damit eine permanente elektrische Verbindung entsteht.

In einer anderen Ausführungsform der Erfindung wird ein Klebstoff mit Flocken aus einem leitenden Material wie Silber verwendet. Dieser Klebstoff ist in alle Richtungen und auch ohne unter Druck zu stehen leitend. Deshalb wird er nur beispielsweise in der Mitte von Kontaktbereichen zwischen den aufeinander montierten Teilen angebracht, und wird jeweils von einem Bereich mit einem anderen, isolierenden Klebstoff umgeben.

Die genannten Teile werden beispielsweise manuell oder automatisch in eine Montagehalterung eingelegt. Die Spule 35 kann auch noch vor dem Einlegen des zweiten Resonators 3' ebenfalls in die Halterung eingelegt und dann mit dem zweiten Resonator 3' verklebt werden. Vorzugsweise wird in einer anderen Vorgehensweise zuerst das aktive Teilmodul 90 ohne die Spule hergestellt und der Klebstoff ausgehärtet. Dann werden ausgewählte elektromechanischen Eigenschaften des aktiven Teilmoduls 90 bestimmt, um Abweichungen von der Norm festzustellen. Beispielsweise ist bekannt, dass ein zu verwendender Schwingungsmodus entsprechend einer der Bewegungsrichtungen bei einer bestimmten Idealfrequenz liegen sollte. In den einzelnen Antrieben wird aber die genaue Frequenz aufgrund von Fertigungsungenauigkeiten variieren. Eine Anregung bei der Idealfrequenz wäre nicht energieeffizent oder gar unwirksam. Deshalb wird durch Messungen bestimmt oder indirekt abgeschätzt, welches beim gegebenen Exemplar die tatsächliche Eigenfrequenz für den gewünschten Schwingungsmodus ist. Dasselbe geschieht für die andere Bewegungsrichtung. Ebenso wird die tatsächliche Kapazität des Piezoelements respektive Anregungsmittels 4 gemessen. Die Eigenfrequenz des Schwingkreises Piezoelement-Spule sollte zumindest annähernd in der Mitte zwischen den notwendigen Anregungsfrequenzen liegen, damit die Spannungserhöhung durch den Schwingkreis bei allen Anregungsfrequenzen möglichst hoch und ausgeglichen ist. Damit wird eine Induktivität der Spule 35 bestimmt, welche die Eigenfrequenz des Schwingkreises entsprechend legt. Eine konkrete Spule 35 mit dem nächstliegenden Induktivitätswert wird aus einem Satz von zur Auswahl stehenden Spulen 35 wird ausgewählt und durch beispielsweise Löten oder Kleben am aktiven Teilmodul 90 montiert.

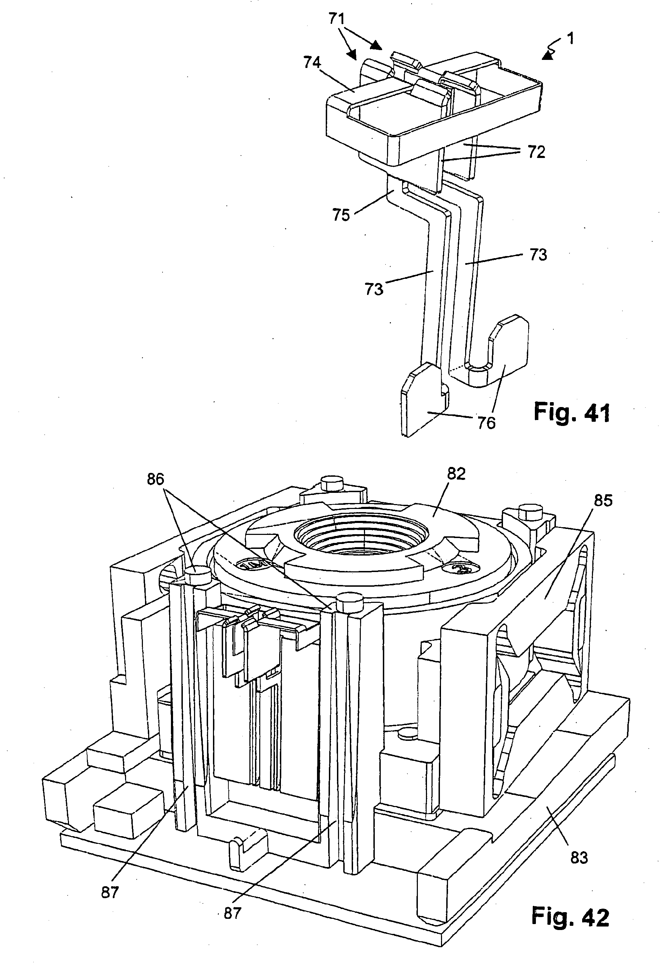

**Figur 41** zeigt ein erfindungsgemässes passives Element 1. Dieses weist zwei parallele Kontaktelemente 71 auf, welche jeweils über einen Kontaktarm 73 mit dem angetriebenen Körper 82 verbunden sind. Um die mechanische Kontaktierung zwischen den Kontaktbereichen 7 der Resonatoren 3,3' und den Kontaktelementen 71 zu optimieren, sind die Kontaktelemente 71 gegen die Kontaktbereiche 7 hin federnd angeordnet. Damit sie sich gegen die Kontaktbereiche 7 hin bewegen können, sind die Kontaktarme 73 relativ lang und flach ausgebildet. Die Fläche der Kontaktarme und der Kontaktplatten 72 verläuft dabei im Wesentlichen senkrecht zur Fläche der Resonatoren 3,3' und parallel zur Bewegungsrichtung des Antriebs. Damit kann auch - zum Ausgleich von Fertigungstoleranzen - eine seitliche Verschiebung des passiven Elements 1 gegenüber dem aktiven Element 2 kompensiert werden, indem die Kontaktplatten 72. sich synchron und parallel miteinander verschieben. In der Bewegungsrichtung des Antriebs selber sind die Kontaktarme 73 vergleichsweise steif, so dass eine Kraftübertragung auf den angetriebenen Körper 82 möglich ist.

Die Kontaktplatten 72 sind also leicht gegen die Kontaktbereiche 7 bewegbar. Um eine Kraft gegen die Kontaktbereiche 7 aufzubringen, wird eine zusätzliche Feder eingesetzt. Diese kann zwischen den Kontaktplatten 72 angeordnet sein, in der vorliegenden Ausführungsform der Erfindung wird die Feder durch ein einstückiges Federelement 74 realisiert, das wie ein Bügel aussen um die beiden Kontaktplatten 72 herumführt, jeweils von aussen in die Kontaktplatten 72 eingreift und sie so auseinander zieht Vorzugsweise ist jeweils eine Endfläche des Federelementes 74 mit der jeweiligen Kontaktplatte 72 verklebt oder verlötet. Vorzugsweise sind die Enden des Federelementes 74 jeweils mit korrespondierenden Halteelementen wie Laschen der Kontaktplatten 72 verhakt Dies ergibt einen zusätzlichen Schlagschutz.

Die Kontaktarme 73 zu einer Kontaktplatte 72 weisen vorzugsweise einen Torsionsbereich 75 auf, der eine Verdrehung der Kontaktplatte 72 um eine Achse senkrecht zu einer Verbindungslinie zwischen den beiden Kontaktbereichen 7, die auf die Kontaktplatte 72 wirken, zulässt Diese Bewegbarkeit, gekoppelt mit der Tatsache, dass die Kraft des Federelementes 74 zwischen den Kontaktbereichen 7 an der Kontaktplatte 72 angreift, bewirkt dass die Kontaktplatte 72 an beide Kontaktbereiche 7 herangezogen wird, sich gegebenenfalls leicht verdreht und dadurch beide Kontaktbereiche 7 zuverlässig kontaktiert.

Am Ende eines Kontaktarme 73, welches der Kontaktplatte 72 gegenüberliegt, ist ein Befestigungsbereich 76 ausgeformt, welcher in eine korrespondierende Öffnung des angetriebenen Körpers 82 gesteckt ist. Ein Kontaktarm 73 mit Kontaktplatte 72 und Befestigungsbereich 76 ist vorzugsweise einstückig und aus einem Blech durch Stanzen und Biegen geformt.

**Figur 42** zeigt die Positionierungseinheit ohne das aktive Teilmodul und mit entferntem Deckelteil 84. Es ist ersichtlich, wie das passive Element 1, gebildet aus Federelement 74, Kontaktplatten 72, und Kontaktarmen 73 mit Befestigungsbereichen 76, am angetriebenen Körper 82 angeordnet ist. Um zur Stoss- oder Schlagsicherung eine übermässige Bewegung der flexiblen Kontaktarme 73 zu verhindern, sind die Kontaktarme 73 teilweise in Schlitzen um angetriebenen Körper 82 geführt, aber freigestellt Im Normalbetrieb berühren also die Kontaktarme 73 die Seitenwände der Schlitze nicht, und es wird verhindert, dass die Kontaktarme 73 bei Schlägen über die Streckgrenze belastet werden oder sich in einer falschen Position verhaken oder verklemmen.

Ferner ist ersichtlich, wie der angetriebene Körper 82 zwischen zwei Stützen 86 des Grundkörpers 83 parallel geführt ist. Jede der Stützen 86 weist einen Schlitz zur Antriebshalterung 87 auf. Bei der Montage des aktiven Teilmoduls 90 ist jeweils ein korrespondierendes Element des aktiven Teilmoduls 90 in diesen Schlitzen verschiebbar. Dadurch sind Ungenauigkeiten durch summierte Fertigungstoleranzen kompensierbar, indem das aktive Teilmodul 90 gegen den Grundkörper 83 geschoben wird, bis die Anschlusslaschen 36, 36' den Grundkörper 83 berühren.

**Figuren 43-44** zeigen weitere Ausführungsformen von aktiven Teilmodulen. **Figur 43** zeigt wie bereits erwähnt eine seitliche Aufhängung der Resonatoren 3,3' im Bereich der Mitte einer Seite der Piezoplatten 64, 64'. Dabei ist der erste Resonator 3 an nur einer Seite, und der zweite Resonator 3' an zwei Seiten jeweils zumindest annährernd mittig aufgehängt. Das Trägerelement 60 dient hier der isolierenden Befestigung der ersten Anschlusslasche 36 mit der Kontaktierungslasche 34 respektive dem Basiselement 33. Dazu sind, wie auch bei der zweiten Anschlusslasche 36', die Bleche auf Kunststoffstifte des Trägerelementes 60 gelegt und mit diesen vernietet. **Figur 44** zeigt Kontaktplatten 72 des passiven Elements 1, die ohne weitere Federung direkt am (nicht gezeigten) angetriebenen Körper 82 befestigt sind, und eine zweiseitige Aufhängung der Zwischenelektrode 62. Um den inneren Aufbau sichtbar zu machen, ist ein Trägerelement 60, welches die Resonatorbleche 37, 37', die Zwischenelektrode 62 und Anschlusslaschen 36, 36' verbindet, nicht eingezeichnet.

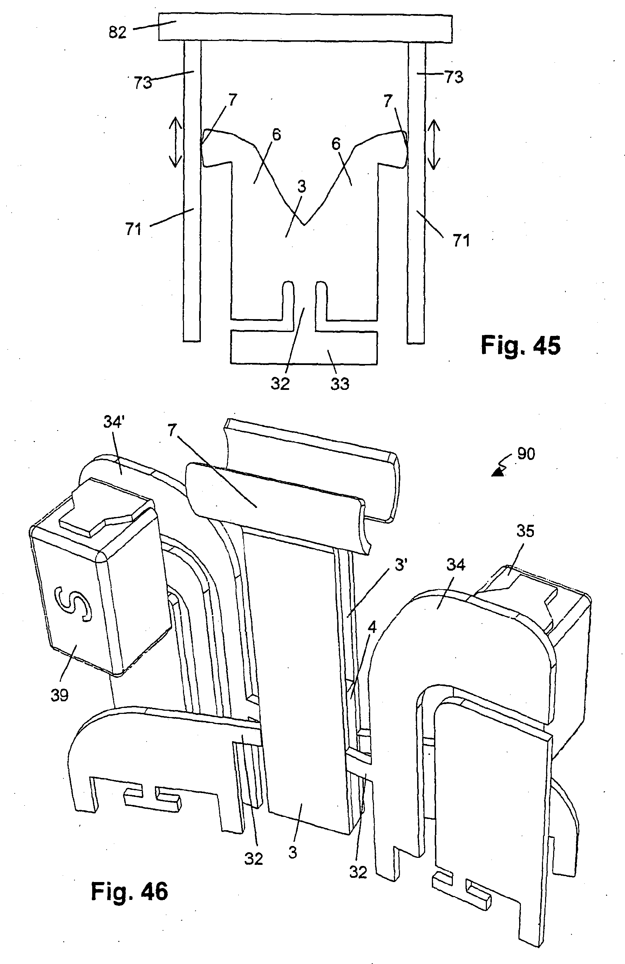

**Figur 45** zeigt schematisch eine weitere Ausführungsform der Erfindung, in welcher die Kontaktbereiche 7 nach aussen hin wirken. Die Aufhängung 32 und die Anregungsmittel 4 sind im Prinzip wie bei den vorangehenden Ausführungsformen gestaltet und entsprechend variierbar. Auch können mehrere, gleich geformte Resonatoren 3 parallel zueinander angeordnet sein. Die antriebswirksamen Schwingungen verlaufen auch hier vorzugsweise hauptsächlich in Ebenen parallel zu dem einen respektive den mehreren Resonatoren 3. Jedoch sind die Kontaktbereiche 7 nach aussen statt nach innen gerichtet Damit ist es möglich, dass das passive Element 1 das aktive Element 2 insbesondere auch im Bereich der Anregungsmittel 4 und der Aufhängung 32 umschliesst Dadurch kann ein längerer Fahrweg des passiven Elements 1 erreicht werden.

Das passive Element 1 ist in sich federnd und vorzugsweise auch bezüglich des aktiven Elements 2 federnd angeordnet. Dazu können die Kontaktelemente 71 selber über die ganze Länge federnd ausgebildet sein oder nur einen federnden Bereich entsprechend einem Kontaktarm 73 aufweisen, und/oder ein Teil des angetriebenen Körpers 82, der die Kontaktelemente 71 verbindet, ist federnd ausgebildet.

**Figur 46** zeigt ein aktives Teilmodul einer weiteren Ausführungsform der Erfindung, in welcher die Kontaktbereiche 7 nach aussen hin wirken. Auch hier sind die Resonatorbleche 37, 37' als Elektroden eines Piezoelementes 4 an diesem angeordnet und verlaufen parallel zur Piezofläche. Die antriebswirksamen Schwingungen verlaufen aber hauptsächlich in Ebenen senkrecht zur Blechebene. Die Aufhängung der Resonatoren 3,3' geschieht an beiden Seite in der Mitte des Piezoelementes 4, senkrecht zur Längsachse der Resonatoren 3,3', und ist ebenfalls elektrisch leitend. Die Aufhängung führt jeweils zu einer einstückig angeformten Kontaktierungslasche 34. Bei Verwendung eines einzigen Piezoelementes 4 ohne Zwischenelektrode befinden sich die beiden Resonatoren 3,3' auf unterschiedlichem elektrischen Potential, weshalb die beiden Teile des passiven Elements 1, welche mit den Resonatoren in Kontakt treten, voneinander elektrisch isoliert sind. Das passive Element 1 ist nicht eingezeichnet; es umfang die Kontaktbereiche 7 von aussen her. Nebst der Spule 35 weist das aktive Teilmodul 90 auch einen Sensor 39 auf, der elektrisch mit einer der Kontaktierungslaschen 34, 34' sowie weiteren Anschlüssen verbunden ist. Der Sensor dient zur Messung der Position des (nicht eingezeichneten) angetriebenen Körpers 82, beispielsweise gemäss einem optischen, kapazitiven oder induktiven etc. Wirkungsprinzip.

In den Ausführungsform en gemäss den **Figuren 35** und **37** bis **46** werden die Piezoelemente vorzugsweise im d31-Modus betrieben.

### BEZUGSZEICHENLISTE

- 1: passives Element
- 2: aktives Element
- 3: Resonator
- 4: Anregungsmittel
- 5: Armpaar
- 6: Arm
- 7: Kontaktbereich
- 8: Federbereich
- 9: flacher Abschnitt
- 10: Verbindungsbereich
- 11: Bewegungsachse
- 12: Symmetrieachse
- 14: Öffnung
- 15: Rotor
- 16: Halteelement
- 17: Befestigungsloch
- 18: verlängerte Arme
- 19: Haltekörper
- 20: freier Bereich
- 21: Rillen
- 22: Halter
- 23: Abstreifer
- 24: Reinigungsmittel
- 25: Spule
- 26: erster Knick
- 27: zweiter Knick
- 28: Kontaktabschnitt
- 29: seitlich hervorstehender Teil
- 30: Ausnehmung
- 31: Versteifungslaschen
- 32: Aufhängung
- 33: Basiselement
- 34: Kontaktierungslasche
- 35: Spule

- 36: Auschlusslasche
- 37: Resonatorblech
- 38: Verbindungslasche
- 39: Sensor
- 41: Mehrfrequenz-Generator
- 42: Frequenzgenerator
- 43: Umschalter
- 44: Verstärker
- 45: Motor
- 46,47: elektrische Anschlussleitungen
- 48: Linse
- 49: Einschnitt
- 51: Übergangsbereich
- 52: Knotenpunkt
- 53: Halterung
- 54: Längsnut
- 60: Trägerelement
- 61: Verbindungsfläche
- 62: Zwischenelektrode
- 64, 64': Piezoplatte
- 71: Kontaktelement
- 72: Kontaktplatte
- 73: Kontaktarm
- 74: Federelement
- 75: Torsionsbereich
- 76: Befestigungsbereich
- 82: angetriebener Körper
- 83: Grundkörper
- 84: Deckelteil
- 85: Parallelmechanik
- 86: Stütze mit Parallelfüturung
- 87: Antriebshalterung
- 90: aktives Teilmodul

## Patentansprüche

1. **Antriebseinheit** zur Bewegung eines aktiven Elements (2) bezüglich eines passiven Elements (1), wobei die Antriebseinheit das aktive Element (2) und das passive Element (1) aufweist, das aktive Element (2) einen Resonator (3) und mindestens ein Anregungsmittel (4) zur Anregung von Oszillationen des Resonators (3) aufweist, der Resonator (3) Kontaktbereiche (7) zum Ausüben von Kräften auf das passive Element (1) aufweist, und das aktive Element (2) bezüglich des passiven Elements (1) durch oszillierende Bewegungen der Kontaktbereiche (7) antreibbar ist, der Resonator (3) mindestens zwei Arme (6), vorzugsweise ein Paar (5) von Armen (6) aufweist, und die mindestens zwei Arme (6) ausgehend von einem Verbindungsbereich (10) des Resonators (3) an derselben Seite des Resonators (3) ausgebildet sind, an den äusseren Enden der Arme (6) jeweils die Kontaktbereiche (7) ausgebildet sind, die Kontaktbereiche (7) durch oszillierende Bewegungen des Armpaares (5) aufeinander zu respektive voneinander weg bewegbar sind und dabei eine Relativbewegung des passiven Elements (1) bezüglich des aktiven Elements (2) bewirkbar ist, **dadurch gekennzeichnet, dass** das passive Element (1) in sich federnd ausgebildet ist, indem ein erstes Kontaktelement (71) des passiven Elements (1), welches einen Kontaktbereich (7) eines ersten Armes (6) des aktiven Elements (2) kontaktiert, und ein zweites Kontaktelement (71) des passiven Elements (1), welches einen Kontaktbereich (7) eines zweites Armes (6) des aktiven Elements (2) kontaktiert, gegeneinander federnd angeordnet sind.

2. Antriebseinheit gemäss Anspruch 1, wobei das passive Element (1) bezüglich einer Bewegung im Bereich der Kontaktbereiche (7) innerhalb der Ebene des Resonators (3) und im Wesentlichen senkrecht zur Bewegungsachse (11) eine über 100, vorzugsweise über 1000 mal kleinere Federkonstante als der Resonator (3) aufweist.

3. Antriebseinheit gemäss einem der bisherigen Ansprüche, wobei das erste und das zweite Kontaktelement (71) parallel zueinander sind und jeweils über einen federnden Kontaktarm (73) mit einem angetriebenen Körper (82) verbunden sind.

4. Antriebseinheit gemäss einem der Ansprüche 1 oder 2, wobei das passive Element (1) einstückig ausgebildet ist.

5. Antriebseinheit gemäss einem der Ansprüche 1 bis 4, wobei eine federnde Verbindung respektive der federnde Kontaktarm (73) zwischen mindestens einem der Kontaktelemente (71) und einem respektive dem angetriebenen Körper (82) einstückig mit einer Kontaktplatte (72) des passiven Elements (1) zur Aufnahme von Antriebskräften geformt ist.

6. Antriebseinheit gemäss Anspruch 5, wobei die federnde Verbindung (73) in einer Richtung zur Übertragung von Antriebskräften starr und in dazu orthogonalen Richtungen nachgiebig ist.

7. Antriebseinheit gemäss Anspruch 6, aufweisend Mittel zur Begrenzung von Bewegungen der federnden Verbindung (73) zur Vermeidung von Schäden bei Schlägen.

8. Antriebseinheit gemäss einem der Ansprüche 1 bis 3 oder 5 bis 7, wobei das passive Element (1) mehrteilig ausgebildet ist und mindestens zwei der Kontaktelemente (71) zur Übertragung von Antriebskräften von den Kontaktbereichen (7) auf einen respektive den angetriebenen Körper (82), sowie mindestens ein Federelement (74), welches die Kontaktelemente (71) in entgegengesetzte Richtungen gegen die Kontaktbereiche (7) drückt, aufweist.

9. Positionierungseinheit zur Positionierung eines optischen Elementes, aufweisend einen Grundkörper (83) und eine dazu verschiebbare Halterung (82), Welche Halterung (82) das optische Element trägt, **dadurch gekennzeichnet, dass** die Positionierungseinheit eine Antriebseinheit gemäss einem der bisherigen Ansprüche aufweist.

## Claims

1. Drive unit for the movement of an active element (2) with respect to a passive element (1), wherein the drive unit comprises the active element (2) and the passive element (1), the active element (2) comprises a resonator (3) and at least one excitation means (4) for exciting oscillations of the resonator (3), the resonator (3) comprises contact regions (7) for exerting forces onto the passive element (1), and the active element (2) may be driven with respect to the passive element (1) by way of oscillating movements of the contact regions (7), the resonator (3) comprises at least two arms (6), preferably a pair (5) of arms (6), and the at least two arms (6), extending from a connection region (10) of the resonator (3), are formed on the same side of the resonator (3), in each case the contact regions (7) are formed at the outer ends of the arms (6), the contact regions (7) are movable towards one another or away from one another by way of oscillating movements of the arm pair (5), and thereby a relative movement of the passive element (1) with respect to the active element (2) may be effected **characterized in that** the passive element (1) is designed to be resilient in itself, by means of a first contact element (71) of the passive element (1), which contacts a contact region (7) of a first arm (6) of the active element (2) and a second contact element (71) of the passive element (1), which contacts a contact region (7) of a second arm (6) of the active element (2), being arranged resiliently towards each other.

2. Drive unit according to claim 1, wherein the passive element (1) with respect to a movement in the region of the contact regions (7) within the plane of the resonator (3) and substantially perpendicular to the movement axis (11) has a spring constant which is over 100, preferably over 1000 times smaller than the resonator (3).

3. Drive unit according to one of the preceding claims, wherein the first and second contact elements (71) are parallel to each other and are connected to a driven body (82) via a respective resilient contact arm (73).

4. Drive unit according to one of claims 1 or 2, wherein the passive element (1) is designed as one piece.

5. Drive unit according to one of claims 1 to 4, wherein a resilient connection is formed respectively the resilient contact arm (73) between at least one of the contact elements (71) and a driven body (82) is formed as one piece with a contact plate (72) of the passive element (1) for accommodating drive forces.

6. Drive unit according to claim 5, wherein the resilient connection (73) is rigid in a direction for transmitting drive forces, and is compliant in directions orthogonal thereto.

7. Drive unit according to claim 6, comprising means for limiting movements of the resilient connection (73) for avoiding damage from impact.

8. Drive unit according to one of claims 1 to 3 or 5 to 7, wherein the passive element (1) is designed of several parts, and comprises at least two of the contact elements (71) for transmitting drive forces from the contact regions (7) onto a or respectively the driven body (82), as well as at least one spring element (74), which presses the contact elements (71) in opposite directions against the contact regions (7).

9. Positioning unit for positioning an optical element, comprising a base body (83) and a holder (82) displaceable thereto, which holder (82) carries the optical element, **characterized in that** the positioning unit comprises a drive unit according to one of the preceding claims.

## Revendications

1. Unité d'entraînement destinée à déplacer un élément actif (2) par rapport à un élément passif (1),
l'unité d'entraînement présentant l'élément actif (2) et l'élément passif (1),
l'élément actif (2) présentant un résonateur (3) et au moins un moyen d'excitation (4) qui excite les oscillations du résonateur (3),
le résonateur (3) présentant des zones de contact (7) qui exercent des forces sur l'élément passif (1) et l'élément actif (2) pouvant être entraîné par rapport à l'élément passif (1) par des déplacements d'oscillation des zones de contact (7),
le résonateur (3) présentant au moins deux bras (6) et de préférence une paire (5) de bras (6) et les deux ou plusieurs bras (6) étant formés sur le même côté du résonateur (3) à partir d'une zone de liaison (10) du résonateur (3),
les zones de contact (7) étant formées sur les extrémités extérieures des bras (6),
les zones de contact (7) pouvant être rapprochées et éloignées les unes des autres par des déplacements oscillants de la paire (5) de bras et ayant ainsi pour effet un déplacement relatif de l'élément passif (1) par rapport à l'élément actif (2),
**caractérisée en ce que**
l'élément passif (1) est intrinsèquement élastique par le fait qu'un premier élément de contact (71) de l'élément passif (1), qui est en contact avec une zone de contact (7) d'un premier bras (6) de l'élément actif (2), et qu'un deuxième élément de contact (71) de l'élément passif (1), qui est en contact avec une zone de contact (7) du deuxième bras (6) de l'élément actif (2), sont agencés élastiquement l'un par rapport à l'autre.

2. Unité d'entraînement selon la revendication 1, dans laquelle l'élément passif (1) présente en vue d'un déplacement dans la partie occupée par les zones de contact (7) dans le plan du résonateur (3) et essentiellement perpendiculairement à l'axe du déplacement (11) une constante élastique inférieure de plus de 100 fois et de préférence de plus de 1 000 fois à celle du résonateur (3).

3. Unité d'entraînement selon l'une des revendications précédentes, dans laquelle le premier et le deuxième élément de contact (71) sont parallèles l'un par rapport à l'autre et sont chacun reliés par un bras élastique de contact (73) à un corps entraîné (82).

4. Unité d'entraînement selon l'une des revendications 1 ou 2, dans laquelle l'élément passif (1) est formé d'une seule pièce.

5. Unité d'entraînement selon l'une des revendications 1 à 4, dans laquelle une liaison élastique ou le bras élastique de contact (73) sont formés entre au moins un des éléments de contact (71) et un ou le corps entraîné (82), d'un seul tenant avec une plaque de contact (72) de l'élément passif (1), pour la reprise des forces d'entraînement.

6. Unité d'entraînement selon la revendication 5, dans laquelle la liaison élastique (73) est rigide dans une direction pour transférer les forces d'entraînement et déformable dans les directions qui y sont perpendiculaires.

7. Unité d'entraînement selon la revendication 6, qui présente des moyens de limitation du déplacement de la liaison élastique (73) en vue d'éviter des dommages en cas de chocs.

8. Unité d'entraînement selon l'une des revendications 1 à 3 ou 5 à 7, dans laquelle l'élément passif (1) est formé en plusieurs pièces et dans laquelle au moins deux des éléments de contact (71) sont configurés pour le transfert des forces d'entraînement entre les zones de contact (7) et un ou le corps entraîné (82), ainsi qu'au moins un élément élastique (74) qui repousse les éléments de contact (71) dans des directions opposées contre les zones de contact (7).

9. Unité de positionnement destinée à positionner un élément optique, qui présente un corps de base (83) et un support (82) apte à coulisser par rapport à ce corps de base, le support (82) portant un élément optique,
**caractérisée en ce que**
l'unité de positionnement présente une unité d'entraînement selon l'une des revendications précédentes.
